(19) Europäisches Patentamt
European Patent Office
Office européen des brevets

(11) EP 3 375 903 A2

# (12) EUROPEAN PATENT APPLICATION

(43) Date of publication:
**19.09.2018 Bulletin 2018/38**

(21) Application number: **18161471.0**

(22) Date of filing: **13.03.2018**

(51) Int Cl.:
***C23C 14/00*** *(2006.01)* ***A44C 27/00*** *(2006.01)*
***C23C 14/02*** *(2006.01)* ***C23C 14/06*** *(2006.01)*
***C23C 14/16*** *(2006.01)* ***C23C 28/00*** *(2006.01)*
***C23C 30/00*** *(2006.01)* ***G04G 17/08*** *(2006.01)*
***G04B 37/22*** *(2006.01)* ***G04B 45/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.03.2017 JP 2017048623**
**14.03.2017 JP 2017048624**

(71) Applicant: **Seiko Epson Corporation**
**Tokyo 160-8801 (JP)**

(72) Inventors:
- **SOGO, Tomohiko**
**Nagano, 392-8502 (JP)**
- **TSUKAMOTO, Yuzuru**
**Nagano, 392-8502 (JP)**
- **KAWAKAMI, Atsushi**
**Nagano, 392-8502 (JP)**
- **TAKAHASHI, Hirokazu**
**Nagano, 392-8502 (JP)**

(74) Representative: **Hoffmann Eitle**
**Patent- und Rechtsanwälte PartmbB**
**Arabellastraße 30**
**81925 München (DE)**

## (54) TIMEPIECE PART, AND TIMEPIECE

(57) A timepiece part according to the invention includes: a substrate; and a first coating configured from a material containing cobalt as a primary component, and 26 mass% to 30 mass% of Cr, and 5 mass% to 7 mass% of Mo. The first coating has a surface with a percentage surface area increase of 0% to 1.2% as measured by atomic force microscopy against a reference flat surface.

EP 3 375 903 A2

## Description

### BACKGROUND

1. Technical Field

The present invention relates to timepiece parts, and a timepiece.

2. Related Art

Aside from being practical items satisfying the functionality requirements, timepieces are also ornaments, and require high aesthetic qualities (aesthetic appearance).

To meet such demands, timepiece parts such as cases and bands use noble metal materials, which provide excellent texture (see, for example, Japanese Patent No. 2990917).

However, noble metal materials are typically expensive, and poor in hardness, which makes the metal easily scratchable (poor abrasion resistance).

It has also been difficult to achieve an external appearance that is moderately glossy but is not too bright, creating a luxurious look with a subdued impression.

### SUMMARY

An advantage of some aspects of the invention is to provide a timepiece part that is aesthetically appealing (specifically, a bright external appearance with a high brightness, or an external appearance that is moderately glossy but is not too bright, creating a luxurious look with a subdued impression) while having excellent corrosion resistance, and excellent abrasion resistance and wear resistance. Another advantage of some aspects of the invention is to provide a timepiece using such a timepiece part.

A timepiece part according to an aspect of the invention includes: a substrate; and a first coating configured from a material containing cobalt as a primary component, and 26 mass% to 30 mass% of Cr, and 5 mass% to 7 mass% of Mo, the first coating having a surface with a percentage surface area increase of 0% to 1.2% as measured by atomic force microscopy against a reference flat surface.

With this configuration, a timepiece part can be provided that is aesthetically appealing (specifically, a bright external appearance with a high brightness) while having excellent corrosion resistance, and excellent abrasion resistance and wear resistance.

A timepiece part according to another aspect of the invention includes: a substrate; and a first coating configured from a material containing cobalt as a primary component, and 26 mass% to 30 mass% of Cr, and 5 mass% to 7 mass% of Mo, the first coating having a surface with a percentage surface area increase of 1.5% to 5.0% as measured by atomic force microscopy against a reference flat surface.

With this configuration, a timepiece part can be provided that is aesthetically appealing (specifically, an external appearance that is moderately glossy but is not too bright, creating a luxurious look with a subdued impression) while having excellent corrosion resistance, and excellent abrasion resistance and wear resistance.

It is preferable that, when the percentage surface area increase is 0% to 1.2%, the timepiece part according to the aspect of the invention has an L* value of 78.5 to 89.0 in an L*a*b* chromaticity diagram as measured according to the JIS Z 8729 specification for a surface on a viewing side of the first coating.

This further increases the brightness of the timepiece part, and the timepiece part can be even more aesthetically appealing with a brighter external appearance.

It is preferable that, when the percentage surface area increase is 1.5% to 5.0%, the timepiece part according to the aspect of the invention has an L* value of 70.0 to 78.4 in an L*a*b* chromaticity diagram as measured according to the JIS Z 8729 specification for a surface on a viewing side of the first coating.

This makes it possible to improve the gloss of the timepiece part, and provide an external appearance having a more luxurious look.

It is preferable in the timepiece part according to the aspect of the invention that the substrate is configured from a material containing at least one of stainless steel and titanium.

This makes it possible to further improve the durability of the timepiece part. Use of the foregoing material also has a desirable effect on the overall external appearance of the timepiece part even when, for example, the first coating is relatively thin, and ensures that the timepiece part has desirable aesthetic qualities as a whole.

It is preferable in the timepiece part according to the aspect of the invention that at least one base layer configured from a titanium-containing material is provided between the substrate and the first coating.

This makes it possible to further improve the durability of the timepiece part. The overall tone of the timepiece

part also can be delicately adjusted to make the timepiece part even more aesthetically appealing.

It is preferable in the timepiece part according to the aspect of the invention that a second coating configured from a material containing at least one of TiC and TiCN is provided between the substrate and the first coating.

With this configuration, the hardness of the timepiece part can further increase, and the dent resistance (resistance against dents) and other properties of the timepiece part can further improve. The durability of the timepiece part also can further improve. The foregoing configuration also enables more desirable tone adjustments (particularly, adjustments of the extent of gloss).

It is preferable in the timepiece part according to the aspect of the invention that a second coating configured from a material containing at least one of TiC and TiCN is provided between the substrate and the first coating, and that the base layer is provided on both sides of the second coating.

This makes it possible to further improve the durability of the timepiece part. The overall tone of the timepiece part also can be delicately adjusted to make the timepiece part even more aesthetically appealing.

It is preferable in the timepiece part according to the aspect of the invention that the second coating has a portion where the composition gradually varies in thickness direction.

With this configuration, the durability of the timepiece part can be further improved while maintaining the effects provided by the second coating, that is to, for example, improve the dent resistance, the abrasion resistance, and the wear resistance of the timepiece part, and to enable desirable tone adjustments (particularly, adjustments of the extent of gloss).

It is preferable in the timepiece part according to the aspect of the invention that the second coating has a region where a total content of carbon and nitrogen decreases toward a surface of the second coating.

With this configuration, the durability of the timepiece part can be further improved while maintaining the effects provided by the second coating, that is to, for example, improve the dent resistance, the abrasion resistance, and the wear resistance of the timepiece part, and to enable desirable tone adjustments (particularly, adjustments of the extent of gloss).

It is preferable in the timepiece part according to the aspect of the invention that the second coating has the region toward both surfaces of the second coating.

With this configuration, the durability of the timepiece part can particularly improve.

It is preferable in the timepiece part according to the aspect of the invention that the second coating has a thickness of 0.05 $\mu$m to 4.0 $\mu$m.

With this configuration, the hardness of the timepiece part can further increase, and the dent resistance (resistance against dents) and other properties of the timepiece part can further improve to make the timepiece part even more durable. The foregoing configuration also enables more desirable and delicate tone adjustments throughout the timepiece part.

It is preferable in the timepiece part according to the aspect of the invention that the first coating has a thickness of 0.02 $\mu$m to 2.0 $\mu$m.

With this configuration, the overall quality of the timepiece part, including gloss, aesthetic, abrasion resistance, and wear resistance, can be further improved while reducing the production cost of the timepiece part. The durability of the timepiece part also can further improve.

It is preferable that the timepiece part according to the aspect of the invention is a case or a band.

These components (timepiece parts) have large impact on the overall external appearance of a timepiece, and the overall aesthetic of a timepiece can greatly improve by applying the invention to these and other timepiece parts. These timepiece parts are typically exposed to outside, and many of these parts contact the skin during use. Among different timepiece parts, such parts are therefore strongly required to have desirable properties, including abrasion resistance and wear resistance, and an anti-allergic property (unlikelihood of causing an allergic reaction). The invention can thus more prominently exhibit its effects when applied to the foregoing parts.

A timepiece of an aspect of the invention includes the timepiece part according to the aspect of the invention.

With this configuration, a timepiece can be provided that includes a timepiece part that is aesthetically appealing (specifically, a bright external appearance with a high brightness, or an external appearance that is moderately glossy but is not too bright, creating a luxurious look with a subdued impression) while having excellent corrosion resistance, and excellent abrasion resistance and wear resistance.

## BRIEF DESCRIPTION OF THE DRAWINGS

The invention will be described with reference to the accompanying drawings, wherein like numbers reference like elements.

FIG. 1 is a cross sectional view schematically illustrating First Embodiment of a timepiece part according to the invention.

FIG. 2 is a cross sectional view schematically illustrating Second Embodiment of the timepiece part according to the invention.

FIG. 3 is a cross sectional view schematically illustrating Third Embodiment of the timepiece part according to the invention.

FIG. 4 is a cross sectional view schematically illustrating Fourth Embodiment of the timepiece part according to the invention.

FIG. 5 is a cross sectional view schematically illustrating Fifth Embodiment of the timepiece part according to the invention.

FIG. 6 is a cross sectional view schematically illustrating Sixth Embodiment of the timepiece part according to the invention.

FIG. 7 is a cross sectional view schematically illustrating Seventh Embodiment of the timepiece part according to the invention.

FIG. 8 is a cross sectional view schematically illustrating Eighth Embodiment of the timepiece part according to the invention.

FIG. 9 is a cross sectional view schematically illustrating Ninth Embodiment of the timepiece part according to the invention.

FIG. 10 is a cross sectional view schematically illustrating Tenth Embodiment of the timepiece part according to the invention.

FIG. 11 is a partial cross sectional view schematically representing a preferred embodiment of a timepiece according to the invention.

## DESCRIPTION OF EXEMPLARY EMBODIMENTS

Preferred embodiments of the invention are described below in detail with reference to the accompanying drawings.

### Timepiece parts

A preferred embodiment of a timepiece part according to the invention is described below.

### First Embodiment

A timepiece part of First Embodiment is described first.

FIG. 1 is a cross sectional view schematically illustrating First Embodiment of the timepiece part according to the invention. The following descriptions are based primarily on the case where the upper side of FIG. 1 is the side viewed by a viewer (the same applies to FIGS. 2 to 10 below) .

A timepiece part 10 of the present embodiment includes a substrate 1, and a first coating 2 configured from a material containing cobalt as a primary component, and 26 mass% to 30 mass% of Cr, and 5 mass% to 7 mass% of Mo.

The surface 22 of the first coating 2 (the second surface 22 opposite the first surface 21 on the side of the substrate 1) has a percentage surface area increase of 0% to 1.2% as measured by atomic force microscopy against a reference flat surface.

With such a configuration, the timepiece part 10 can have excellent corrosion resistance, and excellent abrasion resistance and wear resistance while being aesthetically appealing (specifically, an external appearance with a glossy luxurious look). That is, an external appearance with a glossy luxurious look can be achieved without using a noble metal as a main material. The timepiece part 10 also can have an excellent overall aesthetic and other desirable qualities even when the substrate 1 is configured from various materials, making it possible to use a wide range of materials for the substrate 1. The first coating 2 is configured from a low-allergy material. The first coating 2 can provide high gloss and a desirable aesthetic even when it is relatively thin. This makes it possible to reduce the manufacturing cost of the timepiece part 10, and improve the productivity of the timepiece part 10.

With the percentage surface area increase of the surface (second surface) 22 of the first coating 2 confined in the foregoing range, a bright external appearance with a high brightness can be provided, and the timepiece part 10 can have a particularly desirable aesthetic. The surface of the timepiece part 10 (the surface of the first coating 2, or the second surface 22) also becomes less likely to have stains that are hard to remove, and the anti-staining property of the timepiece part 10 improves.

These desirable effects cannot be obtained unless the foregoing conditions are satisfied.

For example, the corrosion resistance, the abrasion resistance, and the wear resistance become insufficient when the Cr content in the first coating 2 is below the foregoing lower limit.

The aesthetic deteriorates, and a luxurious glossy look cannot be obtained when the Cr content in the first

coating 2 is above the foregoing upper limit.

The abrasion resistance and wear resistance become insufficient when the Mo content in the first coating 2 is below the foregoing lower limit.

The aesthetic deteriorates, and a luxurious glossy look cannot be obtained when the Mo content in the first coating 2 is above the foregoing upper limit.

The abrasion resistance and wear resistance seriously deteriorate when the first coating 2 is configured from a noble metal material such as Pt, rather than a Co-, Cr-, and Mo-containing alloy.

An excessively high percentage surface area increase does not necessarily make the aesthetic of the timepiece part 10 poor. However, the brightness becomes insufficient. For example, it will not be possible to obtain a sufficiently large L* value (described later). This casts a dark tone on the external appearance, and the desired level of gloss cannot be obtained. The anti-staining property of the timepiece part 10 also deteriorates.

The percentage surface area increase of the surface 22 of the first coating 2 represents the percentage of an increased area as a ratio (specific surface area ratio) of the actual surface area (the area of a surface having nanosized microscopic irregularities) of a sample determined by atomic force microscopy against the reference area (projected area) of a surface (flat surface) that is assumed to have no irregularities. In other words, the percentage surface area increase C [%] is defined by the formula

$$C = [(A/B) - 1] \times 100,$$

where A is the actual surface area [$\mu m^2$], and B is the projected area of a measured sample surface that is assumed to be completely flat [$\mu m^2$].

Atomic force microscopy may observe, for example, a 5 $\mu m \times 5$ $\mu m$ region of a sample surface.

Alternatively, more than one field (for example, 5 fields) may be measured, and the mean value may be used to determine the percentage surface area increase.

For atomic force microscopy, for example, the Nanoscope IIIa (available from Digital Instruments) may be used.

For example, the percentage surface area increase condition can be satisfied by adjusting the manufacturing conditions of the timepiece part 10. Specifically, for example, the percentage surface area increase condition can be satisfied by adjusting the deposition conditions of the first coating 2, the surface treatment performed after the formation of the first coating 2 (for example, polishing, and roughening), or the surface conditions of the base material (e.g., substrate 1) before deposition of the first coating 2.

Substrate

The substrate 1 serves as a support for supporting the first coating 2 and other members.

The substrate 1 may be configured from any material. Examples of the material of the substrate 1 include metallic materials such as Al, Ti, V, Cr, Fe, Co, Ni, Cu, Zn, Zr, Nb, Mo, In, Sn, Hf, Ta, W, Bi, and Mg, and alloys containing at least one of these metals; various ceramic materials including oxide ceramics such as alumina, zirconia, and titania, hydroxide ceramics such as hydroxyapatite, nitride ceramics such as silicon nitride, carbide ceramics such as silicon carbide, halide ceramics such as fluorite, carbonate ceramics, and phosphate ceramics; glass materials such as sapphire glass, soda glass, crystalline glass, fused quartz, lead glass, potassium glass, borosilicate glass, and alkali-free glass; and plastic materials such as thermoplastic resins, and curable resins.

Preferred as the substrate 1 are metallic materials. Particularly preferably, the substrate 1 is configured from a material containing at least one of stainless steel, and titanium.

In this way, the substrate 1 can have high strength and high corrosion resistance, and improved adhesion for the first coating 2 and other members, making it possible to further improve the durability of the timepiece part 10. Use of the foregoing materials also has a desirable effect on the overall external appearance of the timepiece part 10 even when, for example, the first coating 2 is relatively thin, and ensures that the timepiece part 10 has a desirable aesthetic as a whole. Because the timepiece part 10 can have sufficient aesthetic qualities even when the first coating 2 is relatively thin, use of the foregoing materials is also advantageous from the standpoint of reducing the production cost of the timepiece part 10.

The titanium may be any of pure titanium, and Ti alloys ($\alpha$ alloy, $\alpha$-$\beta$ alloy, $\beta$ alloy).

The stainless steel may be any of ferrite, austenite, martensite, and austenite-ferrite stainless steels, for example.

Preferred as the ferrite stainless steel is the SUS444 used in the Examples below, because SUS 444, which is a high-purity ferrite 18Cr-2Mo stainless steel with ultra-low carbon and nitrogen contents, excels in pitting corrosion resistance, crevice corrosion resistance, and stress corrosion cracking resistance.

The contents of the stainless steel and titanium in the substrate 1 are preferably 95 mass% or more, more preferably 99 mass% or more.

In this way, the foregoing effects become more prominent.

Preferably, the substrate 1 contains noble metal elements (Au, Ag, Pt, Pd, Rh, Ir, Ru, Os) in sufficiently low contents. The content of the noble metal element in the substrate 1 (the total content when more than one noble metal element is contained) is preferably 1.0 mass% or less, more preferably 0.5 mass% or less, further preferably 0.1 mass% or less.

In this way, the effect that produces a desirable external appearance even without having to use a noble metal as a main material becomes more prominent.

The substrate 1 may have a composition that is uniform throughout the substrate 1, or a composition that differs in different parts of the substrate 1. For example, the substrate 1 may be configured to include a base portion, and at least one film covering the base portion, and having a composition that is different from the composition of the base portion, or may be configured from a gradient material of gradually varying compositions (for example, a gradient material of a composition that gradually varies in thickness direction).

The shape and size of the substrate 1 are not particularly limited, and are typically determined according to the shape and size of the timepiece part 10.

The substrate 1 may have a surface that has been subjected to a surface treatment, for example, such as mirror finishing (polishing), streaking, and pearskin finishing. The substrate 1 also may have indentation patterns such as characters, numbers, symbols, and patterns.

In this way, for example, the timepiece part 10 can have variation in the extent of surface gloss, and can further improve its aesthetic. Particularly, the substrate 1 can have a smoother surface when treated by mirror finishing (polishing). This makes it possible to make the surface of the timepiece part 10 (the surface 22 of the first coating 2) even smoother, and the percentage surface area increase of the surface 22 of the first coating 2 can be confined in the foregoing range with ease. It is to be noted that the films (for example, the first coating 2; described later) typically have a relatively small thickness, and mirror finishing (polishing) of the substrate 1 is easier than mirror finishing (polishing) of the film, and can reduce the percentage of rejects.

For example, known polishing techniques may be used for mirror finishing. Examples of such techniques include buffing, barrel polishing, and other mechanical polishing techniques.

First Coating

The first coating 2 is configured from a material that contains cobalt as a primary component, and 26 mass% to 30 mass% of Cr, and 5 mass% to 7 mass% of Mo.

The first coating 2 configured from such a material has excellent gloss, and is aesthetically appealing, even without containing a noble metal. The first coating 2 also has other desirable qualities, including corrosion resistance, abrasion resistance, and wear resistance.

The first coating 2 contains cobalt as a primary component. The Co content in the first coating 2 is preferably 55 mass% to 69 mass%, more preferably 62 mass% to 68 mass%, further preferably 63 mass% to 67 mass%.

In this way, an aesthetic, and abrasion resistance and wear resistance can be satisfied at higher levels.

The Cr content in the first coating 2 is 26 mass% to 30 mass%. The Cr content in the first coating 2 is preferably 26.2 mass% to 29.8 mass%, more preferably 26.4 mass% to 29.6 mass%, further preferably 26.6 mass% to 29.4 mass%.

In this way, excellent corrosion resistance, and excellent abrasion resistance and wear resistance can be achieved while further improving aesthetic.

The Mo content in the first coating 2 is 5 mass% to 7 mass%. The Mo content in the first coating 2 is preferably 5.2 mass% to 6.8 mass% more preferably 5.3 mass% to 6.7 mass%, further preferably 5.4 mass% to 6.6 mass%.

In this way, an aesthetic, and abrasion resistance and wear resistance can be satisfied at higher levels.

The first coating 2 may contain other components. Examples of such other components include Si, Mn, N, Fe, C, Ni, Ti, Al, Ag, Pt, Pd, Rh, and Ir.

The content of components other than Co, Cr, and Mo in the first coating 2 (the total content when more than one other component is contained) is preferably 3.0 mass% or less, more preferably 2.0 mass% or less, further preferably 1. 5 mass% or less.

The content of a noble metal element (Au, Ag, Pt, Pd, Rh, Ir, Ru, Os) in the first coating 2 (the total content when more than one noble metal element is contained) is preferably 1.0 mass% or less, more preferably 0.5 mass% or less, further preferably 0.1 mass% or less.

In this way, the effect that produces a desirable external appearance even without having to use a noble metal as a main material becomes more prominent.

The first coating 2 may have a composition that is uniform throughout the first coating 2, or a composition that differs in different parts of the first coating 2. For example, the first coating 2 may be configured from a laminate of a plurality of layers, or from a gradient material of gradually varying compositions (for example, a gradient material of a composition that gradually varies in thickness direction). In this way, for example, the adhesion of the first coating 2 for

other members, for example, the substrate 1, can be further improved while maintaining the effect provided by the first coating 2, and the durability of the timepiece part 10 can further improve.

The surface 22 of the first coating 2 has a percentage surface area increase of 0% to 1.2% as measured by atomic force microscopy against a reference flat surface. However, the percentage surface area increase is preferably 0% to 1.1%, more preferably 0% to 1.0%, further preferably more than 0% and 0.9% or less.

In this way, the brightness of the timepiece part 10 increases, and the timepiece part 10 can have a brighter external appearance. That is, the timepiece part 10 becomes even more aesthetically appealing.

The first coating 2 has a thickness of preferably 0.02 μm to 2.0 μm, more preferably 0.04 μm to 1.8 μm, further preferably 0.07 μm to 1.6 μm.

In this way, the overall quality of the timepiece part 10, including gloss, aesthetic, abrasion resistance, and wear resistance, can be further improved while reducing the production cost of the timepiece part 10. Unwanted peeling of the first coating 2 also can be more effectively prevented, and the durability of the timepiece part 10 can further improve.

The method of forming the first coating 2 is not particularly limited. For example, the first coating 2 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the first coating 2 using dry plating (vapor-phase deposition method), it is ensured that the first coating 2 formed has a uniform thickness and quality, and desirably adheres to the substrate 1 and other members. This makes it possible to particularly improve the aesthetic and the durability of the timepiece part 10.

By forming the first coating 2 using dry plating (vapor-phase deposition method), it is also possible to sufficiently reduce unwanted thickness variation, even when the first coating 2 to be formed is relatively thin. This is advantageous in improving the reliability of the timepiece part 10.

When the first coating 2 is formed by sputtering, the flow rate of the Ar gas used for sputtering is preferably 50 ccm to 150 ccm, more preferably 80 ccm to 120 ccm.

In this way, the first coating 2 satisfying the foregoing percentage surface area increase condition can be more desirably formed even when the post-process of the polishing or the like is omitted or simplified.

When the first coating 2 is formed by sputtering, the atmospheric pressure of sputtering is preferably 0.1 Pa to 2.5 Pa, more preferably 0.2 Pa to 1.0 Pa.

In this way, the first coating 2 satisfying the foregoing percentage surface area increase condition can be more desirably formed even when the post-process of the polishing or the like is omitted or simplified.

When the first coating 2 is formed by sputtering, the sputtering apparatus used for sputtering is used at a power of preferably 2 kW to 15 kW, more preferably 6 kW to 12 kW.

In this way, the first coating 2 satisfying the foregoing percentage surface area increase condition can be more desirably formed even when the post-process of the polishing or the like is omitted or simplified.

When the first coating 2 is formed by sputtering, the bias voltage of sputtering is preferably -180 V to -70 V, more preferably -150 V to -90 V.

In this way, the first coating 2 satisfying the foregoing percentage surface area increase condition can be more desirably formed even when the post-process of the polishing or the like is omitted or simplified.

When the first coating 2 is formed by sputtering, the temperature of the substrate 1 at the time of sputtering is preferably 150°C to 250°C, more preferably 180°C to 220°C.

In this way, the first coating 2 satisfying the foregoing percentage surface area increase condition can be more desirably formed even when the post-process of the polishing or the like is omitted or simplified.

The first coating 2 may be subjected to, for example, a surface treatment such as mirror finishing (polishing).

This makes it possible to make the surface 22 of the first coating 2 (the surface of the timepiece part 10) even smoother, and the percentage surface area increase of the surface 22 of the first coating 2 can be more reliably confined in the foregoing range.

The surface 22 of the first coating 2 (the surface on the viewing side of the first coating 2, or the viewing surface on the side of a viewer using the timepiece part 10) has an L* value of preferably 78.5 to 89.0, more preferably 80.0 to 88.5, further preferably 82.0 to 88.0 in an L*a*b* chromaticity diagram according to the JIS Z 8729 specification.

In this way, the brightness of the timepiece part 10 increases, and the timepiece part 10 can have a brighter external appearance. That is, the timepiece part 10 becomes even more aesthetically appealing.

For the measurement of L* value, the light source D65 specified by JIS Z 8720 may be used. The viewing angle for the measurement of L* value may be 2°.

The surface 22 of the first coating 2 (the surface on the viewing side of the first coating 2, or the viewing surface on the side of a viewer using the timepiece part 10) has an a* value of preferably -2.0 to 3.0, more preferably -1.5 to 2.5, further preferably -1.0 to 2.0 in an L*a*b* chromaticity diagram according to the JIS Z 8729 specification.

The surface 22 of the first coating 2 (the surface on the viewing side of the first coating 2, or the viewing surface on the side of a viewer using the timepiece part 10) has a b* value of preferably -1.0 to 10.0, more preferably 0.0 to 9.0, further preferably 1.0 to 8.0 in an L*a*b* chromaticity diagram according to the JIS Z 8729 specification.
The aesthetic of the timepiece part 10 becomes particularly appealing by satisfying these conditions.
For the measurement of a* and b* values, the light source D65 specified by JIS Z 8720 may be used. The viewing angle for the measurement of a* and b* values may be 2°.
The timepiece part 10 may be any component of a timepiece, and is preferably a timepiece component that is viewable from outside during use. Specific examples of such components include cover glasses, cases, bezels, casebacks, bands (including links, clasps, catches, buckles, and a release mechanism for bands and bangles), dials, timepiece hands, rotors, and crowns (for example, screw locking crowns), buttons, dial rings, and panel covers. Preferred are cases and bands.
These components (timepiece parts) have large impact on the overall external appearance of a timepiece, and the overall aesthetic of a timepiece can greatly improve by applying the invention to these and other timepiece parts. These timepiece parts are typically exposed to outside, and many of these parts contact the skin during use. Among different timepiece parts, such parts are therefore strongly required to have desirable properties, including abrasion resistance and wear resistance, and an anti-allergic property (unlikelihood of causing an allergic reaction). The invention can thus more prominently exhibit its effects when applied to the foregoing parts.

Second Embodiment

A timepiece part of Second Embodiment is described below.
FIG. 2 is a cross sectional view schematically illustrating Second Embodiment of the timepiece part according to the invention. The descriptions below will focus primarily on differences from the foregoing embodiment, and the same features will not be described again.
In a timepiece part 10 of the present embodiment, a base layer (first base layer) 3 configured from a titanium-containing material, and a first coating 2 configured from a material containing cobalt as a primary component, and 26 mass% to 30 mass% of Cr, and 5 mass% to 7 mass% of Mo are laminated in this order on a surface of a substrate 1. In other words, in the timepiece part 10 of the present embodiment, the base layer 3 configured from a titanium-containing material is provided between the substrate 1 and the first coating 2.
This further improves the adhesion between the substrate 1 and the first coating 2, and relieves the impact on the timepiece part 10, making it possible to further improve the durability of the timepiece part 10. With the configuration of the present embodiment, the substrate 1 can have a smoother surface, and the overall tone of the timepiece part 10 can be delicately adjusted to make the timepiece part 10 even more aesthetically appealing.
The base layer 3 may contain components other than titanium.
However, the content of the non-titanium component in the base layer is preferably 2.0 mass% or less, more preferably 1.0 mass% or less, further preferably 0.5 mass% or less.
The content of a noble metal element (Au, Ag, Pt, Pd, Rh, Ir, Ru, Os) in the base layer 3 (the total content when more than one noble metal element is contained) is preferably 1.0 mass% or less, more preferably 0.5 mass% or less, further preferably 0.1 mass% or less.
The base layer 3 has a thickness of preferably 0.01 $\mu$m to 1.0 $\mu$m, more preferably 0.02 $\mu$m to 0.5 $\mu$m, further preferably 0.03 $\mu$m to 0.3 $\mu$m.
In this way, the adhesion between the substrate 1 and the first coating 2, and the impact relieving effect can further improve, and the timepiece part 10 becomes more durable. The productivity of the timepiece part 10 also improves, and the production cost of the timepiece part 10 can be more effectively reduced. The substrate 1 also can have a desirably smooth surface, making it easier to confine the percentage surface area increase of the surface 22 of the first coating 2 within the foregoing range.
The method of forming the base layer 3 is not particularly limited. For example, the base layer 3 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).
By forming the base layer 3 using dry plating (vapor-phase deposition method), it is ensured that the base layer 3 formed has a uniform thickness and quality, and desirably adheres to the substrate 1 and other members. This makes it possible to particularly improve the aesthetic and the durability of the timepiece part 10.
By forming the base layer 3 using dry plating (vapor-phase deposition method), it is also possible to sufficiently reduce unwanted thickness variation, even when the base layer 3 to be formed is relatively thin. This is advantageous in improving the reliability of the timepiece part 10.

When the base layer 3 is formed by sputtering, the flow rate of the Ar gas used for sputtering is preferably 50 ccm to 150 ccm, more preferably 80 ccm to 120 ccm.

In this way, the first coating 2 satisfying the foregoing percentage surface area increase condition can be more desirably formed even when the post-process of the polishing or the like is omitted or simplified.

When the base layer 3 is formed by sputtering, the atmospheric pressure of sputtering is preferably 0.1 Pa to 2. 5 Pa, more preferably 0.2 Pa to 1.0 Pa.

In this way, the first coating 2 satisfying the foregoing percentage surface area increase condition can be more desirably formed even when the post-process of the polishing or the like is omitted or simplified.

When the base layer 3 is formed by sputtering, the sputtering apparatus used for sputtering is used at a power of preferably 2 kW to 15 kW, more preferably 6 kW to 12 kW.

In this way, the first coating 2 satisfying the foregoing percentage surface area increase condition can be more desirably formed even when the post-process of the polishing or the like is omitted or simplified.

When the base layer 3 is formed by sputtering, the bias voltage of sputtering is preferably -180 V to -70 V, more preferably -150 V to -90 V.

In this way, the first coating 2 satisfying the foregoing percentage surface area increase condition can be more desirably formed even when the post-process of the polishing or the like is omitted or simplified.

When the base layer 3 is formed by sputtering, the temperature of the substrate 1 at the time of sputtering is preferably 150°C to 250°C, more preferably 180°C to 220°C.

In this way, the first coating 2 satisfying the foregoing percentage surface area increase condition can be more desirably formed even when the post-process of the polishing or the like is omitted or simplified.

The base layer 3 may be subjected to, for example, a surface treatment such as mirror finishing (polishing).

This makes it possible to make the surface of the base layer 3 even smoother, and the surface of the timepiece part 10 (the surface 22 of the first coating 2) can have a smoother surface, enabling the percentage surface area increase of the surface 22 of the first coating 2 to be more reliably confined in the foregoing range.

## Third Embodiment

A timepiece part of Third Embodiment is described below.

FIG. 3 is a cross sectional view schematically illustrating Third Embodiment of the timepiece part according to the invention. The descriptions below will focus primarily on differences from the foregoing embodiments, and the same features will not be described again.

In a timepiece part 10 of the present embodiment, a base layer (first base layer) 3 configured from a titanium-containing material, a second coating 4 configured from a material containing at least one of Tic and TiCN, and a first coating 2 configured from a material containing cobalt as a primary component, and 26 mass% to 30 mass% of Cr, and 5 mass% to 7 mass% of Mo are laminated in this order on a surface of a substrate 1. In other words, the timepiece part 10 of the present embodiment is the same as Second Embodiment, except that the second coating 4 configured from a material containing at least one of TiC and TiCN is provided between the substrate 1 and the first coating 2.

In this way, the hardness of the timepiece part 10 can increase, and the dent resistance (resistance against dents) and other properties of the timepiece part 10 can further improve. The configuration of the present embodiment also can more effectively relieve stress, and can further improve the durability of the timepiece part 10. The foregoing configuration also enables more desirable tone adjustments (particularly, adjustments of the extent of gloss).

The second coating 4 may contain components other than TiC and TiCN.

However, the content of components other than TiC and TiCN in the second coating 4 is preferably 2.0 mass% or less, more preferably 1.0 mass% or less, further preferably 0.5 mass% or less.

Specifically, the content of a noble metal element (Au, Ag, Pt, Pd, Rh, Ir, Ru, Os) in the second coating 4 (the total content when more than one noble metal element is contained) is preferably 1.0 mass% or less, more preferably 0.5 mass% or less, particularly preferably 0.1 mass% or less.

The second coating 4 may have a composition that is uniform throughout the second coating 4, or a composition that differs in different parts of the second coating 4. For example, the second coating 4 may be configured from a laminate of a plurality of layers.

Preferably, the second coating 4 has a portion where the composition gradually varies in thickness direction.

In this way, the adhesion between the second coating 4 and portions adjacent the second coating 4 (the base layer 3 and the first coating 2 in the configuration illustrated in the figure) can further improve while maintaining the effects provided by the second coating 4, that is to, for example, improve the dent resistance, the abrasion resistance, and the wear resistance of the timepiece part 10, and to enable desirable tone adjustments (particularly, adjustments of the extent of gloss). With the foregoing configuration, it is also possible to more effectively prevent the second coating 4 from damage (e.g., interlayer exfoliation), and further improve the durability of the timepiece part 10.

Preferably, the second coating 4 has a region where the total content of carbon and nitrogen decreases toward

the surface 42 of the second coating 4.

In this way, the adhesion between the second coating 4 and portions adjacent the second coating 4 (the base layer 3 and the first coating 2 in the configuration illustrated in the figure) can further improve while maintaining the effects provided by the second coating 4, that is to, for example, improve the dent resistance, the abrasion resistance, and the wear resistance of the timepiece part 10, and to enable desirable tone adjustments (particularly, adjustments of the extent of gloss). With the foregoing configuration, it is also possible to more effectively prevent the second coating 4 from damage (e.g., interlayer exfoliation), and further improve the durability of the timepiece part 10.

The second coating 4 may have a region where the total C and N content decreases from a central portion toward one of surface of the second coating 4 in thickness direction. Preferably, the second coating 4 has a region where the total C and N content decreases from a central portion toward the both surfaces in thickness direction.

In this way, the adhesion between the second coating 4 and portions on the both sides of the second coating 4 (the base layer 3 and the first coating 2 in the configuration illustrated in the figure) becomes particularly desirable, and the durability of the timepiece part 10 can particularly improve.

When the C and N content in a portion where the total content of carbon and nitrogen in the second coating 4 is the highest (for example, at a central portion of the second coating 4 in thickness direction) is X1 [mass%], and the C and N content in a portion where the total content of carbon and nitrogen in the second coating 4 is the lowest (for example, at the surface 42, or the opposite surface) is X2 [mass%], it is preferable to satisfy the relationship $1 \leq X1 - X2 \leq 20$, more preferably $2 \leq X1 - X2 \leq 15$, further preferably $3 \leq X1 - X2 \leq 12$.

In this way, the foregoing effects become more prominent.

The second coating 4 has a thickness of preferably 0.05 μm to 4.0 μm, more preferably 0.1 μm to 2.0 μm, further preferably 0.2 μm to 1.5 μm.

In this way, the hardness of the timepiece part 10 can further increase, and the dent resistance (resistance against dents) and other desirable properties of the timepiece part 10 can further improve to make the timepiece part 10 even more durable. The productivity of the timepiece part 10 also improves, and the production cost of the timepiece part 10 can be more effectively reduced. The foregoing configuration also enables more desirable and delicate tone adjustments throughout the timepiece part 10.

By the provision of the base layer 3, the adhesion between the substrate 1 and the second coating 4 is even more desirable, and the durability of the timepiece part 10 particularly improves.

The method of forming the second coating 4 is not particularly limited. For example, the second coating 4 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the second coating 4 using dry plating (vapor-phase deposition method), it is ensured that the second coating 4 formed has a uniform thickness and quality, and desirably adheres to the base layer 3 and other members. This makes it possible to particularly improve the aesthetic and the durability of the timepiece part 10.

By forming the second coating 4 using dry plating (vapor-phase deposition method), it is also possible to sufficiently reduce unwanted thickness variation, even when the second coating 4 to be formed is relatively thin. This is advantageous in improving the reliability of the timepiece part 10.

When the second coating 4 is formed by sputtering, the flow rate of the Ar gas used for sputtering is preferably 50 ccm to 150 ccm, more preferably 80 ccm to 120 ccm.

In this way, the first coating 2 satisfying the foregoing percentage surface area increase condition can be more desirably formed even when the post-process of the polishing or the like is omitted or simplified.

When the second coating 4 is formed by sputtering, the flow rate of the $C_2H_2$ gas used for sputtering is preferably 10 ccm to 50 ccm, more preferably 15 ccm to 30 ccm.

In this way, the first coating 2 satisfying the foregoing percentage surface area increase condition can be more desirably formed even when the post-process of the polishing or the like is omitted or simplified.

When the second coating 4 is formed by sputtering, the atmospheric pressure of sputtering is preferably 0.1 Pa to 2.5 Pa, more preferably 0.2 Pa to 1.0 Pa.

In this way, the first coating 2 satisfying the foregoing percentage surface area increase condition can be more desirably formed even when the post-process of the polishing or the like is omitted or simplified.

When the second coating 4 is formed by sputtering, the sputtering apparatus used for sputtering is used at a power of preferably 6 kW to 15 kW, more preferably 7 kW to 12 kW.

In this way, the first coating 2 satisfying the foregoing percentage surface area increase condition can be more desirably formed even when the post-process of the polishing or the like is omitted or simplified.

When the second coating 4 is formed by sputtering, the bias voltage of sputtering is preferably -150 V to -30 V, more preferably -120 V to -50 V.

In this way, the first coating 2 satisfying the foregoing percentage surface area increase condition can be more desirably formed even when the post-process of the polishing or the like is omitted or simplified.

When the second coating 4 is formed by sputtering, the temperature of the substrate 1 at the time of sputtering is preferably 150°C to 250°C, more preferably 180°C to 220°C.

In this way, the first coating 2 satisfying the foregoing percentage surface area increase condition can be more desirably formed even when the post-process of the polishing or the like is omitted or simplified.

The second coating 4 may be subjected to, for example, a surface treatment such as mirror finishing (polishing).

This makes it possible to make the surface of the second coating 4 even smoother, and the surface of the timepiece part 10 (the surface 22 of the first coating 2) can have a smoother surface, making it easier to confine the percentage surface area increase of the surface 22 of the first coating 2 in the foregoing range.

The second coating 4 is also applicable to the foregoing First Embodiment, and can produce the same effect.

Fourth Embodiment

A timepiece part of Fourth Embodiment is described below.

FIG. 4 is a cross sectional view schematically illustrating Fourth Embodiment of the timepiece part according to the invention. The descriptions below will focus primarily on differences from the foregoing embodiments, and the same features will not be described again.

In a timepiece part 10 of the present embodiment, a base layer (first base layer) 3 configured from a titanium-containing material, a second coating 4 configured from a material containing at least one of TiC and TiCN, a base layer (second base layer) 5 configured from a titanium-containing material, and a first coating 2 configured from a material containing cobalt as a primary component, and 26 mass% to 30 mass% of Cr, and 5 mass% to 7 mass% of Mo are laminated in this order on a surface of a substrate 1. In other words, in the present embodiment, the second coating 4 configured from a material containing at least one of TiC and TiCN is provided between the substrate 1 and the first coating 2, and the base layer 3 and the base layer 5 are provided on the both sides of the second coating 4.

In this way, the adhesion between the substrate 1 and the second coating 4, and the adhesion between the second coating 4 and the first coating 2 can improve, and the impact on the timepiece part 10 can be relieved more effectively, making it possible to further improve the durability of the timepiece part 10. The second coating 4 also can have a smooth surface, and the overall tone of the timepiece part 10 can be delicately adjusted to make the timepiece part 10 even more aesthetically appealing.

The base layer 5 may contain components other than titanium.

However, the content of a non-titanium component in the base layer 5 is preferably 2.0 mass% or less, more preferably 1.0 mass% or less, further preferably 0.5 mass% or less.

The content of a noble metal element (Au, Ag, Pt, Pd, Rh, Ir, Ru, Os) in the base layer 5 (the total content when more than one noble metal element is contained) is preferably 1.0 mass% or less, more preferably 0.5 mass% or less, further preferably 0.1 mass% or less.

The base layer 5 has a thickness of preferably 0.01 $\mu$m to 1.0 $\mu$m, more preferably 0.02 $\mu$m to 0.5 $\mu$m, further preferably 0.03 $\mu$m to 0.3 $\mu$m.

In this way, the adhesion between the second coating 4 and the first coating 2, and the impact relieving effect can further improve, and the timepiece part 10 becomes more durable. The productivity of the timepiece part 10 also improves, and the production cost of the timepiece part 10 can be more effectively reduced. The second coating 4 also can have a smooth surface, and the overall tone of the timepiece part 10 can be more delicately adjusted.

The method of forming the base layer 5 is not particularly limited. For example, the base layer 5 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the base layer 5 using dry plating (vapor-phase deposition method), it is ensured that the base layer 5 formed has a uniform thickness and quality, and desirably adheres to the second coating 4 and other members. This makes it possible to particularly improve the aesthetic and the durability of the timepiece part 10.

By forming the base layer 5 using dry plating (vapor-phase deposition method), it is also possible to sufficiently reduce unwanted thickness variation, even when the base layer 5 to be formed is relatively thin. This is advantageous in improving the reliability of the timepiece part 10.

When the base layer 5 is formed by sputtering, the flow rate of the Ar gas used for sputtering is preferably 50 ccm to 150 ccm, more preferably 80 ccm to 120 ccm.

In this way, the first coating 2 satisfying the foregoing percentage surface area increase condition can be more desirably formed even when the post-process of the polishing or the like is omitted or simplified.

When the base layer 5 is formed by sputtering, the atmospheric pressure of sputtering is preferably 0.1 Pa to 2.5 Pa, more preferably 0.2 Pa to 1.0 Pa.

In this way, the first coating 2 satisfying the foregoing percentage surface area increase condition can be more desirably formed even when the post-process of the polishing or the like is omitted or simplified.

When the base layer 5 is formed by sputtering, the sputtering apparatus used for sputtering is used at a power of preferably 2 kW to 15 kW, more preferably 6 kW to 12 kW.

In this way, the first coating 2 satisfying the foregoing percentage surface area increase condition can be more desirably formed even when the post-process of the polishing or the like is omitted or simplified.

When the base layer 5 is formed by sputtering, the bias voltage of sputtering is preferably -180 V to -70 V, more preferably -150 V to -90 V.

In this way, the first coating 2 satisfying the foregoing percentage surface area increase condition can be more desirably formed even when the post-process of the polishing or the like is omitted or simplified.

When the base layer 5 is formed by sputtering, the temperature of the substrate 1 at the time of sputtering is preferably 150°C to 250°C, more preferably 180°C to 220°C.

In this way, the first coating 2 satisfying the foregoing percentage surface area increase condition can be more desirably formed even when the post-process of the polishing or the like is omitted or simplified.

The base layer 5 may be subjected to, for example, a surface treatment such as mirror finishing (polishing).

This makes it possible to make the surface of the base layer 5 even smoother, and the surface of the timepiece part 10 (the surface 22 of the first coating 2) can have a smoother surface, enabling the percentage surface area increase of the surface 22 of the first coating 2 to be more reliably confined in the foregoing range.

Fifth Embodiment

A timepiece part of Fifth Embodiment is described below.

FIG. 5 is a cross sectional view schematically illustrating Fifth Embodiment of the timepiece part according to the invention. The descriptions below will focus primarily on differences from the foregoing embodiments, and the same features will not be described again.

In a timepiece part 10 of the present embodiment, a base layer (first base layer) 3 configured from a titanium-containing material, a second coating 4 configured from a material containing at least one of TiC and TiCN, a base layer (second base layer) 5 configured from a titanium-containing material, a first coating 2 configured from a material containing cobalt as a primary component, and 26 mass% to 30 mass% of Cr, and 5 mass% to 7 mass% of Mo, and a coating layer 6 configured from a material containing a fluorine-containing organosilicon compound are laminated in this order on a surface of a substrate 1. In other words, the timepiece part 10 of the present embodiment is the same as Fourth Embodiment, except that the coating layer 6 configured from a material containing a fluorine-containing organosilicon compound is provided on the outer surface side of the first coating 2.

In this way, deterioration of aesthetic qualities due to staining can be effectively prevented. A stain also can be removed with ease. This makes it possible to maintain the desirable aesthetic over extended time periods in a variety of environments. Other properties, including texture, and a waterproofing property also improve by the provision of the coating layer 6 configured from a material containing a fluorine-containing organosilicon compound, in addition to the anti-staining property. The fluorine-containing organosilicon compound has little impact on the overall external appearance of the timepiece part 10, and aesthetic of the timepiece part 10 can more reliably improve.

Specific examples of the fluorine-containing organosilicon compound include $CF_3(CF_2)_2C_2H_4Si(OCH_3)_3$, $CF_3(CF_2)_4C_2H_4Si(OCH_3)_3$, $CF_3(CF_2)_6C_2H_4Si(OCH_3)_3$, $CF_3(CF_2)_8C_2H_4Si(OCH_3)_3$, $CF_3(CF_2)_{10}C_2H_4Si(OCH_3)_3$, $CF_3(CF_2)_{12}C_2H_4Si(OCH_3)_3$, $CF_3(CF_2)_{14}C_2H_4Si(OCH_3)_3$, $CF_3(CF_2)_{16}C_2H_4Si(OCH_3)_3$, $CF_3(CF_2)_{18}C_2H_4Si(OCH_3)_3$, $CF_3(CF_2)_6C_2H_4Si(OC_2H_5)_3$, $CF_3(CF_2)_8C_2H_4Si(OC_2H_5)_3$, $CF_3(CF_2)_6C_2H4SiCl_3$, $CF_3(CF_2)_8C_2H4SiCl_3$, $CF_3(CF_2)_6C_3H_6Si(OCH_3)_3$, $CF_3(CF_2)_8C_3H_6Si(OCH_3)_3$, $CF_3(CF_2)_6C_3H_6Si(OC_2H_5)_3$, $CF_3(CF_2)_8C_3H_6Si(OC_2H_5)_3$, $CF_3(CF_2)_6C_3H_6SiCl_3$, $CF_3(CF_2)_8C_3H_6SiCl_3$, $CF_3(CF_2)_6C_4H_8Si(OCH_3)_3$, $CF_3(CF_2)_8C_4H_8Si(OCH_3)_3$, $CF_3(CF_2)_6C_4H_8Si(OC_2H_5)_3$, $CF_3(CF_2)_8C_4H_8Si(OC_2H_5)_3$, $CF_3(CF_2)_6C_2H_4Si(CH_3)(OCH_3)_2$, $CF_3(CF_2)_8C_2H_4Si(CH_3)(OCH_3)_2$, $CF_3(CF_2)_6C_2H_4Si(CH_3)Cl_2$, $CF_3(CF_2)_8C_2H_4Si(CH_3)Cl_2$, $CF_3(CF_2)_6C_2H_4Si(C_2H_5)(OC_2H_5)_2$, and $CF_3(CF_2)_8C_2H_4Si(C_2H_5)(OC_2H_5)_2$.

Also preferred for use as the fluorine-containing organosilicon compound are compounds containing an amino group.

Examples of the amino group-containing fluorine-containing organosilicon compounds include $C_9F_{19}CONH(CH_2)_3Si(OC_2H_5)_3$, $C_9F_{19}CONH(CH_2)_3SiCl_3$, $C_9F_{19}CONH(CH_2)_3Si(CH_3)Cl_2$, $C_9F_{19}CONH(CH_2)NH(CH_2)Si(OC_2H_5)_3$, $C_9F_{19}CONH(CH_2)_5CONH(CH_2)Si(OC_2H_5)_3$, $C_8F_{17}SO_2NH(CH_2)_5CONH(CH_2)Si(OC_2H_5)_3$, $C_3F_7O(CF(CF_3)CF_2O)_2$-$CF(CF_3)$-$CONH(CH_2)Si(OC_2H_5)_3$, and $C_3F_7O(CF(CF_3)CF_2O)_{m'}$-$CF(CF_3)$-$CONH(CH_2)Si(OCH_3)_3$, wherein m' represents an integer of 1 or more.

Also usable as the fluorine-containing organosilicon compound are, for example, $R_f'(CH_2)_2SiCl_3$,

$R_f'(CH_2)_2Si(CH_3)Cl_2$, $(R_fCH_2CH_2)_2SiCl_2$, $R_f'(CH_2)_2Si(OCH_3)_3$, $R_f'CONH(CH_2)_3Si(OC_2H_5)_3$, $R_f'CONH(CH_2)_2NH(CH_2)_3Si(OC_2H_5)_3$, $R_f'SO_2N(CH_3)(CH_2)_2CONH(CH_2)_3Si(OC_2H_5)_3$, $R_f'(CH_2)_2OCO(CH_2)_2S(CH_2)_3Si(OCH_3)_3$, $R_f'(CH_2)_2OCONH(CH_2)_2Si(OC_2H_5)_3$, $R_f'COO\text{-}Cy(OH)\text{-}(CH_2)_2Si(OCH_3)_3$, $R_f'(CH_2)_2NH(CH_2)_2Si(OCH_3)_3$, and $R_f'(CH_2)_2NH(CH_2)_2NH(CH_2)_2Si(OCH_2CH_2OCH_3)_3$. In these formulae, Cy represents a cyclohexane residue, $R_f'$ represents a polyfluoroalkyl group of 4 to 16 carbon atoms.

Particularly preferred as the fluorine-containing organosilicon compound constituting the coating layer 6 are compounds represented by the following formula (1) or (2).

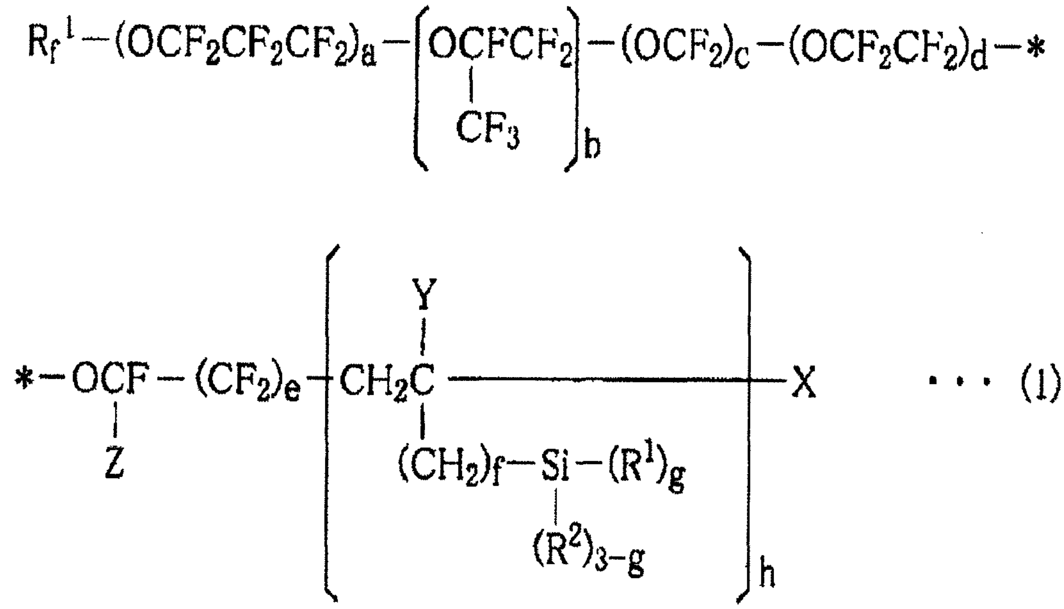

• • • (1)

In formula (1), $R_f^1$ represents a perfluoroalkyl group, X represents bromine, iodine, or hydrogen, Y represents hydrogen or a lower alkyl group, Z represents fluorine or a trifluoromethyl group, $R^1$ represents a hydrolyzable group, and $R^2$ represents hydrogen or an inert monovalent hydrocarbon group. The symbols a, b, c, d, and e represent integers of 0, or 1 or more, wherein a + b + c + d + e is 1 or more, and the order of the occurrence of the repeating units denoted by a, b, c, d, and e are not limited in the formula. The symbol f represents 0 , 1, or 2, g represents 1, 2, or 3, and h represents an integer of 1 or more.

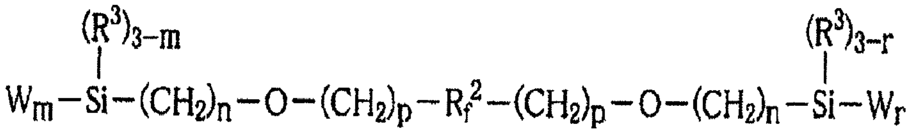

• • • (2)

In formula (2), $R_f^2$ represents a divalent group having a unbranched linear perfluoropolyalkylene ether structure containing a unit represented by the formula $-(C_kF_{2k})O-$, wherein k in the formula $(C_kF_{2k})O-$ represents an integer of 1 to 6. $R^3$ represents a monovalent hydrocarbon group of 1 to 8 carbon atoms, W represents a hydrolyzable group or a halogen atom, p represents 0, 1, or 2, n represents an integer of 1 to 5, and m and r represent 2 or 3.

The coating layer 6 has a thickness of preferably 0.01 μm to 1.0 μm, more preferably 0.02 μm to 0.5 μm, further preferably 0.03 μm to 0.3 μm.

The coating layer 6 is also applicable to any of the foregoing First to Third Embodiments, and can produce the same effect.

Sixth Embodiment

A timepiece part of Sixth Embodiment is described below.

FIG. 6 is a cross sectional view schematically illustrating Sixth Embodiment of the timepiece part according to the invention. The descriptions below will focus primarily on differences from the foregoing embodiments, and the same features will not be described again.

A timepiece part 110 of the present embodiment includes a substrate 101, and a first coating 102 configured

from a material containing cobalt as a primary component, and 26 mass% to 30 mass% of Cr, and 5 mass% to 7 mass% of Mo.

The surface 122 of the first coating 102 (the second surface 122 opposite the first surface 121 on the side of the substrate 101) has a percentage surface area increase of 1.5% to 5.0% as measured by atomic force microscopy against a reference flat surface.

With such a configuration, the timepiece part 110 can have excellent corrosion resistance, and excellent abrasion resistance and wear resistance while being aesthetically appealing (specifically, an external appearance that is moderately glossy but is not too bright, creating a luxurious look with a subdued impression). Such a desirable external appearance can be achieved without using a noble metal as a main material. The timepiece part 110 also can have an excellent aesthetic and other desirable qualities even when the substrate 101 is configured from various materials, making it possible to use a wide range of materials for the substrate 101. The first coating 102 is configured from a low-allergy material. The first coating 102 can provide a desirable aesthetic even when it is relatively thin. This makes it possible to reduce the manufacturing cost of the timepiece part 110, and improves the productivity of the timepiece part 110.

With the percentage surface area increase of the surface (second surface) 122 of the first coating 102 confined in the foregoing range, it is possible to achieve an external appearance that is moderately glossy but is not too bright, creating a luxurious look with a subdued impression. This makes the aesthetic of the timepiece part 110 particularly desirable. The timepiece part 110 also becomes more resistant to scratch or damage. Even when scratched or damaged, the scratch is less noticeable, and the aesthetic of the timepiece part 110 is maintained.

The foregoing desirable effects cannot be obtained unless these conditions are satisfied.

For example, the corrosion resistance, the abrasion resistance, and the wear resistance become insufficient when the Cr content in the first coating 102 is below the foregoing lower limit.

The aesthetic deteriorates, and a luxurious glossy look cannot be obtained when the Cr content in the first coating 102 is above the foregoing upper limit.

The abrasion resistance and wear resistance become insufficient when the Mo content in the first coating 102 is below the foregoing lower limit.

The aesthetic deteriorates, and a luxurious glossy look cannot be obtained when the Mo content in the first coating 102 is above the foregoing upper limit.

The abrasion resistance and wear resistance seriously deteriorate when the first coating 102 is configured from a noble metal material such as Pt, rather than a Co-, Cr-, and Mo-containing alloy.

An excessively low percentage surface area increase does not necessarily make the aesthetic of the timepiece part 110 poor. However, the external appearance becomes too bright and gives an ostentatious impression, and cannot provide a subdued luxurious look. The timepiece part 110 also becomes more susceptible to scratch or damage. When scratched or damaged, the scratch becomes more noticeable, and often leads to deterioration of the aesthetic of the timepiece part 110.

An excessively high percentage surface area increase makes the brightness insufficient, and the desired level of gloss cannot be obtained. The aesthetic of the timepiece part 110 deteriorates accordingly.

The percentage surface area increase of the surface 122 of the first coating 102 is as defined for the percentage surface area increase of the surface 22 of the first coating 2, and will not be described again.

The percentage surface area increase condition can be satisfied by, for example, adjusting the manufacturing conditions of the timepiece part 110. Specifically, for example, the percentage surface area increase condition can be satisfied by adjusting the deposition conditions of the first coating 102, the surface treatment performed after the formation of the first coating 102 (for example, polishing, and roughening), or the surface conditions of the base material (substrate 101) before deposition of the first coating 102.

## Substrate

The substrate 101 serves as a support for supporting the first coating 102 and other members.

The substrate 101 is configured from the same material used for the substrate 1. Among the materials of the substrate 101, preferred as the substrate 101 are metallic materials. Particularly preferably, the substrate 101 is configured from a material containing at least one of stainless steel, and titanium.

In this way, the substrate 101 can have high strength and high corrosion resistance, and improved adhesion for the first coating 102 and other members, making it possible to further improve the durability of the timepiece part 110. Use of the foregoing materials also has a desirable effect on the overall external appearance of the timepiece part 110 even when, for example, the first coating 102 is relatively thin, and ensures that the timepiece part 110 has a desirable aesthetic as a whole. Because the timepiece part 110 can have sufficient aesthetic qualities even when the first coating 102 is relatively thin, use of the foregoing materials is also advantageous from the standpoint of reducing the production cost of the timepiece part 110.

The titanium, and the stainless steel are the same as in the foregoing embodiments.

The contents of the stainless steel and titanium in the substrate 101 are preferably 95 mass% or more, more preferably 99 mass% or more.

In this way, the foregoing effects become more prominent.

Preferably, the substrate 101 contains noble metal elements (Au, Ag, Pt, Pd, Rh, Ir, Ru, Os) in sufficiently low contents. The content of the noble metal element in the substrate 101 (the total content when more than one noble metal element is contained) is preferably 1.0 mass% or less, more preferably 0.5 mass% or less, further preferably 0.1 mass% or less.

In this way, the effect that produces a desirable external appearance even without having to use a noble metal as a main material becomes more prominent.

The substrate 101 may have a composition that is uniform throughout the substrate 101, or a composition that differs in different parts of the substrate 101. For example, the substrate 101 may be configured to include a base portion, and at least one film covering the base portion, and having a composition that is different from the composition of the base portion, or may be configured from a gradient material of gradually varying compositions (for example, a gradient material of a composition that gradually varies in thickness direction).

The shape and size of the substrate 101 are not particularly limited, and are typically determined according to the shape and size of the timepiece part 110.

The substrate 101 may have a surface that has been subjected to a surface treatment, for example, such as mirror finishing (polishing), roughening treatment (roughening), streaking, and pearskin finishing. The substrate 101 also may have indentation patterns such as characters, numbers, symbols, and patterns.

In this way, for example, the timepiece part 110 can have variation in the extent of surface gloss, and can further improve its aesthetic.

Particularly, the substrate 101 can have a smoother surface when treated by mirror finishing (polishing). This makes it possible to make the surface of the timepiece part 110 (the surface 122 of the first coating 102) even smoother. It is to be noted that the films (for example, the first coating 102; described later) typically have a relatively small thickness, and mirror finishing (polishing) of the substrate 101 is easier than mirror finishing (polishing) of the film, and can reduce the percentage of rejects.

By a roughening treatment (roughening), the substrate 101 can have a moderately rough surface state, and the surface of the timepiece part 110 (the surface 122 of the first coating 102) can more reliably satisfy the foregoing percentage surface area increase condition. The adhesion of the substrate 101 for other members, for example, the first coating 102 also can improve, making it possible to further improve the durability of the timepiece part 110. It is to be noted that the films (for example, the first coating 102; described later) typically have a relatively small thickness, and a roughening treatment (roughening) of the substrate 101 is easier than a roughening treatment (roughening) of the film, and can reduce the percentage of rejects.

Particularly, by a combination of mirror finishing (polishing) and a roughening treatment (roughening), the surface of the timepiece part 110 (the surface 122 of the first coating 102) can more reliably satisfy the foregoing percentage surface area increase condition.

Preferably, mirror finishing (polishing) is followed by roughening treatment (roughening) when mirror finishing (polishing) and a roughening treatment (roughening) are performed in combination. This ensures that the foregoing effects are more reliably obtained.

For example, known polishing techniques may be used for mirror finishing. Examples of such techniques include buffing, barrel polishing, and other mechanical polishing techniques.

Examples of the roughening treatment include plasma etching, and blasting.

First Coating

The first coating 102 is configured from a material that contains cobalt as a primary component, and 26 mass% to 30 mass% of Cr, and 5 mass% to 7 mass% of Mo.

The first coating 102 configured from such a material has gloss with a luxurious look creating a subdued impression, and is aesthetically appealing, even without containing a noble metal. The first coating 102 also has other desirable qualities, including corrosion resistance, abrasion resistance, and wear resistance.

The first coating 102 contains cobalt as a primary component. The Co content in the first coating 102 is preferably 55 mass% to 69 mass%, more preferably 62 mass% to 68 mass%, further preferably 63 mass% to 67 mass%.

In this way, an aesthetic, and abrasion resistance and wear resistance can be satisfied at higher levels.

The Cr content in the first coating 102 is 26 mass% to 30 mass%. The Cr content in the first coating 102 is preferably 26.2 mass% to 29.8 mass%, more preferably 26.4 mass% to 29.6 mass%, further preferably 26.6 mass% to 29.4 mass%.

In this way, excellent corrosion resistance, and excellent abrasion resistance and wear resistance can be

achieved while further improving aesthetic.

The Mo content in the first coating 102 is 5 mass% to 7 mass%. The Mo content in the first coating 102 is preferably 5.2 mass% to 6.8 mass%, more preferably 5.3 mass% to 6.7 mass%, further preferably 5.4 mass% to 6.6 mass%.

In this way, an aesthetic, and abrasion resistance and wear resistance can be satisfied at higher levels.

The first coating 102 may contain other components. Examples of such other components include Si, Mn, N, Fe, C, Ni, Ti, Al, Ag, Pt, Pd, Rh, and Ir.

The content of components other than Co, Cr, and Mo in the first coating 102 (the total content when more than one other component is contained) is preferably 3.0 mass% or less, more preferably 2.0 mass% or less, further preferably 1. 5 mass% or less.

The content of a noble metal element (Au, Ag, Pt, Pd, Rh, Ir, Ru, Os) in the first coating 102 (the total content when more than one noble metal element is contained) is preferably 1.0 mass% or less, more preferably 0.5 mass% or less, further preferably 0.1 mass% or less.

In this way, the effect that produces a desirable external appearance even without having to use a noble metal as a main material becomes more prominent.

The first coating 102 may have a composition that is uniform throughout the first coating 102, or a composition that differs in different parts of the first coating 102. For example, the first coating 102 may be configured from a laminate of a plurality of layers, or from a gradient material of gradually varying compositions (for example, a gradient material of a composition that gradually varies in thickness direction). In this way, for example, the adhesion of the first coating 102 for other members, for example, the substrate 101, can be further improved while maintaining the effect provided by the first coating 102, and the durability of the timepiece part 110 can further improve.

The surface 122 of the first coating 102 has a percentage surface area increase of 1.5% to 5.0% as measured by atomic force microscopy against a reference flat surface. However, the percentage surface area increase is preferably 1.6% to 4.5% more preferably 1.7% to 4.0%, further preferably 1.8% to 3.5%.

In this way, the timepiece part 110 can have a more subdued luxurious look, and becomes even more aesthetically appealing.

The first coating 102 has a thickness of preferably 0.02 μm to 2.0 μm, more preferably 0.04 μm to 1.8 μm, further preferably 0.07 μm to 1.6 μm.

The overall quality of the timepiece part 110, including gloss, aesthetic, abrasion resistance, and wear resistance, can be further improved while reducing the production cost of the timepiece part 110. Unwanted peeling of the first coating 102 also can be more effectively prevented, and the durability of the timepiece part 110 can further improve.

The method of forming the first coating 102 is not particularly limited. For example, the first coating 102 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the first coating 102 using dry plating (vapor-phase deposition method), it is ensured that the first coating 102 formed has a uniform thickness and quality, and desirably adheres to the substrate 101 and other members. This makes it possible to particularly improve the aesthetic and the durability of the timepiece part 110.

By forming the first coating 102 using dry plating (vapor-phase deposition method), it is also possible to sufficiently reduce unwanted thickness variation, even when the first coating 102 to be formed is relatively thin. This is advantageous in improving the reliability of the timepiece part 110.

When the first coating 102 is formed by sputtering, the flow rate of the Ar gas used for sputtering is preferably 50 ccm to 150 ccm, more preferably 80 ccm to 120 ccm.

In this way, the first coating 102 satisfying the percentage surface area increase condition can be more desirably formed even when the post-process of the polishing or the like is omitted or simplified.

When the first coating 102 is formed by sputtering, the atmospheric pressure of sputtering is preferably 2.0 Pa to 7.0 Pa, more preferably 2.6 Pa to 6.0 Pa.

In this way, the first coating 102 satisfying the percentage surface area increase condition can be more desirably formed even when the post-process of the polishing or the like is omitted or simplified.

When the first coating 102 is formed by sputtering, the sputtering apparatus used for sputtering is used at a power of preferably 0.1 kW to 1.8 kW, more preferably 0.3 kW to 1.4 kW.

In this way, the first coating 102 satisfying the percentage surface area increase condition can be more desirably formed even when the post-process of the polishing or the like is omitted or simplified.

When the first coating 102 is formed by sputtering, the bias voltage of sputtering is preferably -120 V to -10 V, more preferably -80 V to -30 V.

In this way, the first coating 102 satisfying the percentage surface area increase condition can be more desirably

formed even when the post-process of the polishing or the like is omitted or simplified.

When the first coating 102 is formed by sputtering, the temperature of the substrate 101 at the time of sputtering is preferably 70°C to 170°C, more preferably 80°C to 145°C.

In this way, the first coating 102 satisfying the foregoing percentage surface area increase condition can be more desirably formed even when the post-process of the polishing or the like is omitted or simplified.

The first coating 102 may be subjected to, for example, a surface treatment such as mirror finishing (polishing), and a roughening treatment (roughening).

In this way, the surface of the timepiece part 110 (the surface 122 of the first coating 102) can more reliably satisfy the percentage surface area increase condition described above.

Particularly, by a combination of mirror finishing (polishing) and a roughening treatment (roughening), the surface of the timepiece part 110 (the surface 122 of the first coating 102) can more reliably satisfy the percentage surface area increase condition described above.

Preferably, mirror finishing (polishing) is followed by roughening treatment (roughening) when mirror finishing (polishing) and a roughening treatment (roughening) are performed in combination. In this way, the foregoing effect can be more reliably obtained.

The surface 122 of the first coating 102 (the surface on the viewing side of the first coating 102, or the viewing surface on the side of a viewer using the timepiece part 110) has an L* value of preferably 70.0 to 78.4, more preferably 72.0 to 78.3, further preferably 74.0 to 78.2 in an L*a*b* chromaticity diagram according to the JIS Z 8729 specification.

In this way, the timepiece part 110 can have more desirable gloss, and becomes even more aesthetically appealing.

For the measurement of L* value, the light source D65 specified by JIS Z 8720 may be used. The viewing angle for the measurement of L* value may be 2°.

The surface 122 of the first coating 102 (the surface on the viewing side of the first coating 102, or the viewing surface on the side of a viewer using the timepiece part 110) has an a* value of preferably -2.0 to 3.0, more preferably -1.5 to 2.5, further preferably -1.0 to 2.0 in an L*a*b* chromaticity diagram according to the JIS Z 8729 specification.

The surface 122 of the first coating 102 (the surface on the viewing side of the first coating 102, or the viewing surface on the side of a viewer using the timepiece part 110) has a b* value of preferably -1.0 to 10.0, more preferably 0.0 to 9.0, further preferably 1.0 to 8.0 in an L*a*b* chromaticity diagram according to the JIS Z 8729 specification.

The aesthetic of the timepiece part 110 becomes particularly appealing by satisfying these conditions.

For the measurement of a* and b* values, the light source D65 specified by JIS Z 8720 may be used. The viewing angle for the measurement of a* and b* values may be 2°.

The timepiece part 110 may be any component of a timepiece, and is preferably a timepiece component that is viewable from outside during use. Specific examples of such components include cover glasses, cases, bezels, casebacks, bands (including links, clasps, catches, buckles, and a release mechanism for bands and bangles), dials, timepiece hands, rotors, and crowns (for example, screw locking crowns), buttons, dial rings, and panel covers. Preferred are cases and bands.

These components (timepiece parts) have large impact on the overall external appearance of a timepiece, and the overall aesthetic of a timepiece can greatly improve by applying the invention to these and other timepiece parts. These timepiece parts are typically exposed to outside, and many of these parts contact the skin during use. Among different timepiece parts, such parts are therefore strongly required to have desirable properties, including abrasion resistance and wear resistance, and an anti-allergic property (unlikelihood of causing an allergic reaction). The invention can thus more prominently exhibit its effects when applied to the foregoing parts.

## Seventh Embodiment

A timepiece part of Seventh Embodiment is described below.

FIG. 7 is a cross sectional view schematically illustrating Seventh Embodiment of the timepiece part according to the invention. The descriptions below will focus primarily on differences from the foregoing embodiment, and the same features will not be described again.

In a timepiece part 110 of the present embodiment, a base layer (first base layer) 103 configured from a titanium-containing material, and a first coating 102 configured from a material containing cobalt as a primary component, and 26 mass% to 30 mass% of Cr, and 5 mass% to 7 mass% of Mo are laminated in this order on a surface of a substrate 101. In other words, in the timepiece part 110 of the present embodiment, the base layer 103 configured from a titanium-containing material is provided between the substrate 101 and the first coating 102.

This further improves the adhesion between the substrate 101 and the first coating 102, and relieves the impact on the timepiece part 110, making it possible to further improve the durability of the timepiece part 110. With the configuration of the present embodiment, the substrate 101 can have a smoother surface, and the overall tone of the timepiece part 110 can be delicately adjusted to make the timepiece part 110 even more aesthetically appealing.

The base layer 103 may contain components other than titanium. However, the content of the non-titanium component in the base layer 103 is preferably 2.0 mass% or less, more preferably 1.0 mass% or less, further preferably 0.5 mass% or less.

The content of a noble metal element (Au, Ag, Pt, Pd, Rh, Ir, Ru, Os) in the base layer 103 (the total content when more than one noble metal element is contained) is preferably 1. 0 mass% or less, more preferably 0. 5 mass% or less, further preferably 0.1 mass% or less.

The base layer 103 has a thickness of preferably 0.01 μm to 1.0 μm, more preferably 0.02 μm to 0.5 μm, further preferably 0.03 μm to 0.3 μm.

In this way, the adhesion between the substrate 101 and the first coating 102, and the impact relieving effect can further improve, and the timepiece part 110 becomes more durable. The productivity of the timepiece part 110 also improves, and the production cost of the timepiece part 110 can be more effectively reduced. It also becomes easier to confine the percentage surface area increase of the surface 122 of the first coating 102 within the foregoing range, for example, even when the surface treatment, for example, polishing and roughening, performed for the substrate 101 is omitted or simplified.

The method of forming the base layer 103 is not particularly limited. For example, the base layer 103 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the base layer 103 using dry plating (vapor-phase deposition method), it is ensured that the base layer 103 formed has a uniform thickness and quality, and desirably adheres to the substrate 101 and other members. This makes it possible to particularly improve the aesthetic and the durability of the timepiece part 110.

By forming the base layer 103 using dry plating (vapor-phase deposition method), it is also possible to sufficiently reduce unwanted thickness variation, even when the base layer 103 to be formed is relatively thin. This is advantageous in improving the reliability of the timepiece part 110.

When the base layer 103 is formed by sputtering, the flow rate of the Ar gas used for sputtering is preferably 50 ccm to 150 ccm, more preferably 80 ccm to 120 ccm.

In this way, the first coating 102 satisfying the foregoing percentage surface area increase condition can be more desirably formed even when the post-process of the polishing or the like is omitted or simplified.

When the base layer 103 is formed by sputtering, the atmospheric pressure of sputtering is preferably 2. 0 Pa to 7. 0 Pa, more preferably 2.6 Pa to 6.0 Pa.

In this way, the first coating 102 satisfying the foregoing percentage surface area increase condition can be more desirably formed even when the post-process of the polishing or the like is omitted or simplified.

When the base layer 103 is formed by sputtering, the sputtering apparatus used for sputtering is used at a power of preferably 0.1 kW to 1.8 kW, more preferably 0.3 kW to 1.4 kW.

In this way, the first coating 102 satisfying the foregoing percentage surface area increase condition can be more desirably formed even when the post-process of the polishing or the like is omitted or simplified.

When the base layer 103 is formed by sputtering, the bias voltage of sputtering is preferably -120 V to -10 V, more preferably -80 V to -30 V.

In this way, the first coating 102 satisfying the foregoing percentage surface area increase condition can be more desirably formed even when the post-process of the polishing or the like is omitted or simplified.

When the base layer 103 is formed by sputtering, the temperature of the substrate 101 at the time of sputtering is preferably 70°C to 170°C, more preferably 80°C to 145°C.

In this way, the first coating 102 satisfying the foregoing percentage surface area increase condition can be more desirably formed even when the post-process of the polishing or the like is omitted or simplified.

The base layer 103 may be subjected to, for example, a surface treatment such as mirror finishing (polishing), and a roughening treatment (roughening).

In this way, the surface of the timepiece part 110 (the surface 122 of the first coating 102) can satisfy the foregoing percentage surface area increase condition.

Particularly, by a combination of mirror finishing (polishing) and a roughening treatment (roughening), the surface of the timepiece part 110 (the surface 122 of the first coating 102) can more reliably satisfy the percentage surface area increase condition described above.

Preferably, mirror finishing (polishing) is followed by roughening treatment (roughening) when mirror finishing (polishing) and a roughening treatment (roughening) are performed in combination. In this way, the foregoing effect can be more reliably obtained.

Eighth Embodiment

A timepiece part of Eighth Embodiment is described below.

FIG. 8 is a cross sectional view schematically illustrating Eighth Embodiment of the timepiece part according to the invention. The descriptions below will focus primarily on differences from the foregoing embodiments, and the same features will not be described again.

In a timepiece part 110 of the present embodiment, a base layer (first base layer) 103 configured from a titanium-containing material, a second coating 104 configured from a material containing at least one of TiC and TiCN, and a first coating 102 configured from a material containing cobalt as a primary component, and 26 mass% to 30 mass% of Cr, and 5 mass% to 7 mass% of Mo are laminated in this order on a surface of a substrate 101. In other words, the timepiece part 110 of the present embodiment is the same as Seventh Embodiment, except that the second coating 104 configured from a material containing at least one of TiC and TiCN is provided between the substrate 101 and the first coating 102.

In this way, the hardness of the timepiece part 110 can increase, and the dent resistance (resistance against dents) and other properties of the timepiece part 110 can further improve. The configuration of the present embodiment also can more effectively relieve stress, and can further improve the durability of the timepiece part 110. The foregoing configuration also enables more desirable tone adjustments (particularly, adjustments of the extent of gloss).

The second coating 104 may contain components other than TiC and TiCN. However, the content of components other than TiC and TiCN in the second coating 104 is preferably 2.0 mass% or less, more preferably 1.0 mass% or less, further preferably 0.5 mass% or less.

Specifically, the content of a noble metal element (Au, Ag, Pt, Pd, Rh, Ir, Ru, Os) in the second coating 104 (the total content when more than one noble metal element is contained) is preferably 1.0 mass% or less, more preferably 0.5 mass% or less, particularly preferably 0.1 mass% or less.

The second coating 104 may have a composition that is uniform throughout the second coating 104, or a composition that differs in different parts of the second coating 104. For example, the second coating 104 may be configured from a laminate of a plurality of layers.

Preferably, the composition gradually varies in thickness direction in portions of the second coating 104.

In this way, the adhesion between the second coating 104 and portions adj acent the second coating 104 (the base layer 103 and the first coating 102 in the configuration illustrated in the figure) can further improve while maintaining the effects provided by the second coating 104, that is to, for example, improve the dent resistance, the abrasion resistance, and the wear resistance of the timepiece part 110, and to enable desirable tone adjustments (particularly, adjustments of the extent of gloss). With the foregoing configuration, it is also possible to more effectively prevent damage (e.g., interlayer exfoliation) of the second coating 104, and further improve the durability of the timepiece part 110.

Preferably, the second coating 104 has a region where the total content of carbon and nitrogen decreases toward the surface 142 of the second coating 104.

In this way, the adhesion between the second coating 104 and portions adjacent the second coating 104 (the base layer 103 and the first coating 102 in the configuration illustrated in the figure) can further improve while maintaining the effects provided by the second coating 104, that is to, for example, improve the dent resistance, the abrasion resistance, and the wear resistance of the timepiece part 110, and to enable desirable tone adjustments (particularly, adjustments of the extent of gloss). With the foregoing configuration, it is also possible to more effectively prevent damage (e.g., interlayer exfoliation) of the second coating 104, and further improve the durability of the timepiece part 110.

The second coating 104 may have a region where the total C and N content decreases from a central portion toward one surface of the second coating 104 in thickness direction. Preferably, the second coating 104 has a region where the total C and N content decreases from a central portion toward the both surfaces in thickness direction.

In this way, the adhesion between the second coating 104 and portions on the both sides of the second coating 104 (the base layer 103 and the first coating 102 in the configuration illustrated in the figure) becomes particularly desirable, and the durability of the timepiece part 110 can particularly improve.

When the C and N content in a portion where the total content of carbon and nitrogen in the second coating 104 is the highest (for example, at a central portion of the second coating 104 in thickness direction) is X1 [mass%], and the C and N content in a portion where the total content of carbon and nitrogen in the second coating 104 is the lowest (for example, at the surface 142, or the opposite surface) is X2 [mass%], it is preferable to satisfy the relationship $1 \leq X1 - X2 \leq 20$, more preferably $2 \leq X1 - X2 \leq 15$, further preferably $3 \leq X1 - X2 \leq 12$. In this way, the foregoing effects become more prominent.

The second coating 104 has a thickness of preferably 0.05 μm to 4.0 μm, more preferably 0.1 μm to 2.0 μm, further preferably 0.2 μm to 1.5 μm.

In this way, the hardness of the timepiece part 110 can further increase, and the dent resistance (resistance against dents) and other desirable properties of the timepiece part 110 can further improve to make the timepiece part 110 even more durable. The productivity of the timepiece part 110 also improves, and the production cost of the timepiece

part 110 can be more effectively reduced. The foregoing configuration also enables more desirable and delicate tone adjustments throughout the timepiece part 110.

By the provision of the base layer 103, the adhesion between the substrate 101 and the second coating 104 is even more desirable, and the durability of the timepiece part 110 particularly improves.

The method of forming the second coating 104 is not particularly limited. For example, the second coating 104 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the second coating 104 using dry plating (vapor-phase deposition method), it is ensured that the second coating 104 formed has a uniform thickness and quality, and desirably adheres to the base layer 103 and other members. This makes it possible to particularly improve the aesthetic and the durability of the timepiece part 110.

By forming the second coating 104 using dry plating (vapor-phase deposition method), it is also possible to sufficiently reduce unwanted thickness variation, even when the second coating 104 to be formed is relatively thin. This is advantageous in improving the reliability of the timepiece part 110.

When the second coating 104 is formed by sputtering, the flow rate of the Ar gas used for sputtering is preferably 50 ccm to 150 ccm, more preferably 80 ccm to 120 ccm.

In this way, the first coating 102 satisfying the foregoing percentage surface area increase condition can be more desirably formed even when the post-process of the polishing or the like is omitted or simplified.

When the second coating 104 is formed by sputtering, the flow rate of the $C_2H_2$ gas used for sputtering is preferably 10 ccm to 50 ccm, more preferably 15 ccm to 30 ccm.

In this way, the first coating 102 satisfying the foregoing percentage surface area increase condition can be more desirably formed even when the post-process of the polishing or the like is omitted or simplified.

When the second coating 104 is formed by sputtering, the atmospheric pressure of sputtering is preferably 2.0 Pa to 7.0 Pa, more preferably 2.6 Pa to 6.0 Pa.

In this way, the first coating 102 satisfying the foregoing percentage surface area increase condition can be more desirably formed even when the post-process of the polishing or the like is omitted or simplified.

When the second coating 104 is formed by sputtering, the sputtering apparatus used for sputtering is used at a power of preferably 2.0 kW to 6 kW, more preferably 2.5 kW to 5.8 kW.

In this way, the first coating 102 satisfying the foregoing percentage surface area increase condition can be more desirably formed even when the post-process of the polishing or the like is omitted or simplified.

When the second coating 104 is formed by sputtering, the bias voltage of sputtering is preferably -150 V to -30 V, more preferably -120 V to -50 V.

In this way, the first coating 102 satisfying the foregoing percentage surface area increase condition can be more desirably formed even when the post-process of the polishing or the like is omitted or simplified.

When the second coating 104 is formed by sputtering, the temperature of the substrate 101 at the time of sputtering is preferably 70°C to 170°C, more preferably 80°C to 145°C.

In this way, the first coating 102 satisfying the foregoing percentage surface area increase condition can be more desirably formed even when the post-process of the polishing or the like is omitted or simplified.

The second coating 104 may be subjected to, for example, a surface treatment such as mirror finishing (polishing), and a roughening treatment (roughening).

In this way, the surface of the timepiece part 110 (the surface 122 of the first coating 102) can more reliably satisfy the foregoing percentage surface area increase condition.

Particularly, by a combination of mirror finishing (polishing) and a roughening treatment (roughening), the surface of the timepiece part 110 (the surface 122 of the first coating 102) can even more reliably satisfy the percentage surface area increase condition described above.

Preferably, mirror finishing (polishing) is followed by roughening treatment (roughening) when mirror finishing (polishing) and a roughening treatment (roughening) are performed in combination. In this way, the foregoing effect can be more reliably obtained.

The second coating 104 is also applicable to the foregoing Sixth Embodiment, and can produce the same effect.

Ninth Embodiment

A timepiece part of Ninth Embodiment is described below.

FIG. 9 is a cross sectional view schematically illustrating Ninth Embodiment of the timepiece part according to the invention. The descriptions below will focus primarily on differences from the foregoing embodiments, and the same features will not be described again.

In a timepiece part 110 of the present embodiment, a base layer (first base layer) 103 configured from a titanium-containing material, a second coating 104 configured from a material containing at least one of TiC and TiCN, a base layer (second base layer) 105 configured from a titanium-containing material, and a first coating 102 configured from a material containing cobalt as a primary component, and 26 mass% to 30 mass% of Cr, and 5 mass% to 7 mass% of Mo are laminated in this order on a surface of a substrate 101. In other words, in the present embodiment, the second coating 104 configured from a material containing at least one of TiC and TiCN is provided between the substrate 101 and the first coating 102, and the base layers 103 and 105 are provided on the both sides of the second coating 104.

In this way, the adhesion between the substrate 101 and the second coating 104, and the adhesion between the second coating 104 and the first coating 102 can improve, and the impact on the timepiece part 110 can be relieved more effectively, making it possible to further improve the durability of the timepiece part 110. The second coating 104 also can have a smooth surface, and the overall tone of the timepiece part 110 can be delicately adjusted to make the timepiece part 110 even more aesthetically appealing.

The base layer 105 may contain components other than titanium. However, the content of a non-titanium component in the base layer 105 is preferably 2.0 mass% or less, more preferably 1.0 mass% or less, further preferably 0.5 mass% or less.

The content of a noble metal element (Au, Ag, Pt, Pd, Rh, Ir, Ru, Os) in the base layer 105 (the total content when more than one noble metal element is contained) is preferably 1.0 mass% or less, more preferably 0.5 mass% or less, further preferably 0.1 mass% or less.

The base layer 105 has a thickness of preferably 0.01 $\mu$m to 1.0 $\mu$m, more preferably 0.02 $\mu$m to 0.5 $\mu$m, further preferably 0.03 $\mu$m to 0.3 $\mu$m.

In this way, the adhesion between the second coating 104 and the first coating 102, and the impact relieving effect can further improve, and the timepiece part 110 becomes more durable. The productivity of the timepiece part 110 also improves, and the production cost of the timepiece part 110 can be more effectively reduced. The second coating 104 also can have a smooth surface, and the overall tone of the timepiece part 110 can be more delicately adjusted.

The method of forming the base layer 105 is not particularly limited. For example, the base layer 105 may be formed by coating such as spin coating, dipping, brush coating, spray coating, electrostatic coating, and electrodeposition coating; wet plating such as electrolytic plating, immersion plating, and non-electrolytic plating; chemical vapor deposition methods (CVD) such as thermal CVD, plasma CVD, and laser CVD; dry plating (vapor-phase deposition method) such as vacuum vapor deposition, sputtering, ion plating, and laser abrasion; and thermal spraying. Preferred is dry plating (vapor-phase deposition method).

By forming the base layer 105 using dry plating (vapor-phase deposition method), it is ensured that the base layer 105 formed has a uniform thickness and quality, and desirably adheres to the second coating 104 and other members. This makes it possible to particularly improve the aesthetic and the durability of the timepiece part 110.

By forming the base layer 105 using dry plating (vapor-phase deposition method), it is also possible to sufficiently reduce unwanted thickness variation, even when the base layer 105 to be formed is relatively thin. This is advantageous in improving the reliability of the timepiece part 110.

When the base layer 105 is formed by sputtering, the flow rate of the Ar gas used for sputtering is preferably 50 ccm to 150 ccm, more preferably 80 ccm to 120 ccm.

In this way, the first coating 102 satisfying the foregoing percentage surface area increase condition can be more desirably formed even when the post-process of the polishing or the like is omitted or simplified.

When the base layer 105 is formed by sputtering, the atmospheric pressure of sputtering is preferably 2. 0 Pa to 7. 0 Pa, more preferably 2.6 Pa to 6.0 Pa.

In this way, the first coating 102 satisfying the foregoing percentage surface area increase condition can be more desirably formed even when the post-process of the polishing or the like is omitted or simplified.

When the base layer 105 is formed by sputtering, the sputtering apparatus used for sputtering is used at a power of preferably 0.1 kW to 1.8 kW, more preferably 0.3 kW to 1.4 kW.

In this way, the first coating 102 satisfying the foregoing percentage surface area increase condition can be more desirably formed even when the post-process of the polishing or the like is omitted or simplified.

When the base layer 105 is formed by sputtering, the bias voltage of sputtering is preferably -120 V to -10 V, more preferably -80 V to -30 V.

In this way, the first coating 102 satisfying the foregoing percentage surface area increase condition can be more desirably formed even when the post-process of the polishing or the like is omitted or simplified.

When the base layer 105 is formed by sputtering, the temperature of the substrate 101 at the time of sputtering is preferably 70°C to 170°C, more preferably 80°C to 145°C.

In this way, the first coating 102 satisfying the foregoing percentage surface area increase condition can be more desirably formed even when the post-process of the polishing or the like is omitted or simplified.

The base layer 105 may be subjected to, for example, a surface treatment such as mirror finishing (polishing), and a roughening treatment (roughening).

In this way, the surface of the timepiece part 110 (the surface 122 of the first coating 102) can more reliably satisfy the foregoing percentage surface area increase condition.

Tenth Embodiment

A timepiece part of Tenth Embodiment is described below.
FIG. 10 is a cross sectional view schematically illustrating Tenth Embodiment of the timepiece part according to the invention. The descriptions below will focus primarily on differences from the foregoing embodiments, and the same features will not be described again.
In a timepiece part 110 of the present embodiment, a base layer (first base layer) 103 configured from a titanium-containing material, a second coating 104 configured from a material containing at least one of TiC and TiCN, a base layer (second base layer) 105 configured from a titanium-containing material, a first coating 102 configured from a material containing cobalt as a primary component, and 26 mass% to 30 mass% of Cr, and 5 mass% to 7 mass% of Mo, and a coating layer 106 configured from a material containing a fluorine-containing organosilicon compound are laminated in this order on a surface of a substrate 101. In other words, the timepiece part 110 according to the invention is the same as Ninth Embodiment, except that the coating layer 106 configured from a material containing a fluorine-containing organosilicon compound is provided on the outer surface side of the first coating 102.
In this way, deterioration of aesthetic qualities due to staining can be effectively prevented. A stain also can be removed with ease. This makes it possible to maintain the desirable aesthetic over extended time periods in a variety of environments. Other properties, including texture, and a waterproofing property also improve by the provision of the coating layer 106 configured from a material containing a fluorine-containing organosilicon compound, in addition to the anti-staining property. The fluorine-containing organosilicon compound has little impact on the overall external appearance of the timepiece part 110, and aesthetic of the timepiece part 110 can more reliably improve.
With the surface 122 of the first coating 102 having the predetermined percentage surface area increase, the adhesion between the first coating 102 and the coating layer 106 can improve. In this way, unwanted peeling of the first coating layer 106 can be more effectively prevented, and the durability of the timepiece part 110 can improve.
Specific examples of the fluorine-containing organosilicon compound are as listed in the foregoing Fifth Embodiment, and will not be described again.
Also preferred for use as the fluorine-containing organosilicon compound are compounds containing an amino group.
The fluorine-containing organosilicon compounds containing an amino group, and the fluorine-containing organosilicon compounds are the same as in Fifth Embodiment, and will not be described again.
The fluorine-containing organosilicon compound constituting the coating layer 106 is as described for the coating layer 6 of the foregoing embodiments, and will not be described again.
The coating layer 106 has a thickness of preferably 0.01 μm to 1.0 μm, more preferably 0.02 μm to 0.5 μm, further preferably 0.03 μm to 0.3 μm.
The coating layer 106 is also applicable to any of the foregoing Sixth to Eighth Embodiments, and can produce the same effect.

Watch

A preferred embodiment of a timepiece according to the invention is described below.
FIG. 11 is a partial cross sectional view schematically representing a preferred embodiment of a timepiece (wristwatch) according to the invention.
A wristwatch (watch) W10 of the present embodiment includes a case band (case) W22, a caseback W23, a bezel (rim) W24, and a glass plate (cover glass) W25. A movement (for example, with a dial and hands; not illustrated) is housed inside the case W22.
A stem pipe W26 is fitted into the case band W22 and fixed thereto, and a shaft portion W271 of a crown W27 is rotatably inserted in the stem pipe W26.
The case band W22 and the bezel W24 are fixed with a plastic gasket W28. The bezel W24 and the glass plate W25 are fixed with a plastic gasket W29.
The caseback W23 is fitted (or screwed) to the case band W22, and a ring-like rubber gasket (caseback gasket) W40 is inserted under compression at the joint (sealing portion) W50 connecting these members. With this configuration, the sealing portion W50 is sealed liquid-tight, and a waterproof ing function is provided.
A groove W272 is formed on the outer circumference of the shaft portion W271 of the crown W27, and a ring-like rubber gasket (crown gasket) W30 is fitted into the groove W272. The rubber gasket W30 is tightly in contact with the inner circumferential surface of the stem pipe W26, and compressed between this surface and the inner surface of the groove W272. With this configuration, the crown W27 and the stem pipe W26 are sealed liquid-tight, and a waterproofing function is provided. When the crown W27 is rotated, the rubber gasket W30 follows the rotation of the crown W27 with the shaft portion W271, and slides in circumferential direction against the inner circumferential surface of the stem pipe W26 by maintaining contact with this surface.

The wristwatch W10 as an embodiment of a timepiece according to the invention uses the timepiece part of any of the foregoing embodiments for at least one of its components. In other words, a timepiece according to the invention includes a timepiece part according to the invention.

In this way, a timepiece W10 can be provided that includes a timepiece part having excellent corrosion resistance, and excellent abrasion resistance and wear resistance while being aesthetically appealing (specifically, a bright external appearance with a high brightness, or an appearance that is moderately glossy but is not too bright, creating a luxurious look with a subdued impression).

While the invention has been described with reference to preferred embodiments of the invention, it is to be understood that the invention is not limited to the foregoing embodiments.

For example, the configurations of different parts of the timepiece part and the timepiece according to the invention may be replaced with any other configurations that exhibit the same or similar functions. Addition of other configurations is also possible.

For example, the timepiece part may have a base layer configured from materials other than titanium, or may have a coating layer configured from materials other than the fluorine-containing organosilicon compound.

In the foregoing embodiments, the timepiece part having the base layer was described as being configured to include one or two base layers. However, the timepiece part according to the invention may include three or more base layers. In the foregoing embodiments, the timepiece part having the second coating was described as being configured to include one second coating. However, the timepiece part according to the invention may include two or more second coatings.

The timepiece part according to the invention may include more than one set of the base layer and the second coating.

The descriptions of the foregoing embodiments are based primarily on the case where the viewer viewing the timepiece part, for example, when using it, is the first coating side of the timepiece part. However, the viewer's side may be the opposite side when, for example, the substrate is configured from a transparent material. In other words, the first coating may be viewable through the substrate. In this case, the surface of the first coating opposite the substrate on the viewer's side may satisfy the percentage surface area increase condition described above.

## Examples

The following describes specific examples of the invention. In the descriptions below, a magnetron sputtering device (AS14G, available from ProChina) was used for sputtering.

### 1. Production of Timepiece part

#### Example 1

First, a pure titanium substrate of a shape corresponding to a wristwatch case was prepared.

The substrate surface (the surface on which the first coating is to be formed) was buffed, and measured with an atomic force microscope. The percentage surface area increase relative to a reference flat surface was 0.7%.

The substrate was washed after the foregoing polishing process. The substrate was washed by being subjected to 30 seconds of alkali electrolytic degreasing, 10 seconds of neutralization, 10 seconds of water washing, and 10 seconds of washing with purified water.

The substrate was then sputtered, and a 0.5 μm-thick first coating configured from a CoCrMo alloy was formed on the substrate surface to obtain a wristwatch case as a timepiece part. The first coating was formed under the following conditions. Ar gas flow rate: 100 ccm, atmospheric pressure: 0.3 Pa, power: 9 kW, bias voltage: -120 V, and substrate temperature: 200°C.

Atomic force microscopy revealed that the surface of the first coating (second surface) had a percentage surface area increase of 0.7% relative to the reference flat surface.

Atomic force microscopy was carried out for different fields in five 5 μm × 5 μm regions of a sample surface, and the percentage surface area increase was determined form each region. The mean value of the results was then used as the percentage surface area increase of the surface. For atomic force microscopy, the Nanoscope IIIa (available from Digital Instruments) was used in all Examples and Comparative Examples.

Example 2

A timepiece part (wristwatch case) was produced in the same manner as in Example 1, except that an unpolished ferrite stainless steel SUS444 was used as the substrate (the substrate had a percentage surface area increase of 2.5% relative to the reference flat surface as measured by atomic force microscopy for the surface on which the first coating was to be formed), and that the first coating was buffed.

Example 3

First, a pure titanium substrate of a shape corresponding to a wristwatch case was prepared.

The substrate surface (the surface on which the base layer and the first coating are to be formed) was buffed, and measured with an atomic force microscope. The percentage surface area increase relative to the reference flat surface was 0.7%.

The substrate was washed after the foregoing polishing process. The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick base layer (first base layer) configured from titanium was formed on the substrate surface. The base layer was formed under the following conditions. Ar gas flow rate: 100 ccm, atmospheric pressure: 0.3 Pa, power: 9 kW, bias voltage: -80 V, substrate temperature: 200°C.

By sputtering, a 0.5 μm-thick first coating configured from a CoCrMo alloy was formed on the base layer surface to obtain a wristwatch case as a timepiece part. The first coating was formed under the following conditions. Ar gas flow rate: 100 ccm, atmospheric pressure: 0.3 Pa, power: 9 kW, bias voltage: -120 V, and substrate temperature: 200°C.

Example 4

A timepiece part (wristwatch case) was produced in the same manner as in Example 3, except that an unpolished SUS444 was used as the substrate (the substrate had a percentage surface area increase of 2.5% relative to the reference flat surface as measured by atomic force microscopy for the surface on which the base layer and the first coating were to be formed), and that the first coating was formed using a different composition for the target CoCrMo alloy used for the formation of the first coating, and was buffed after being formed.

Example 5

First, a pure titanium substrate of a shape corresponding to a wristwatch case was prepared.

The substrate surface (the surface on which the base layer, the second coating, and the first coating are to be formed) was buffed, and measured with an atomic force microscope. The percentage surface area increase relative to the reference flat surface was 0.7%.

The substrate was washed after the foregoing polishing process. The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick base layer configured from titanium was formed on the substrate surface. The base layer was formed under the following conditions. Ar gas flow rate: 100 ccm, atmospheric pressure: 0.3 Pa, power: 9 kW, bias voltage: -80V, substrate temperature: 200°C.

By sputtering, a 0.35 μm-thick second coating configured from TiC was formed on the base layer surface. The second coating was formed under the following conditions. Ar gas flow rate: 100 ccm, flow rate of $C_2H_2$ gas: 22 ccm, atmospheric pressure: 0.3 Pa, power: 9 kW, bias voltage: -80 V, substrate temperature: 200°C.

By sputtering, a 0.5 μm-thick first coating configured from a CoCrMo alloy was formed on the second coating surface to obtain a wristwatch case as a timepiece part. The first coating was formed under the following conditions. Ar gas flow rate: 100 ccm, atmospheric pressure: 0.3 Pa, power: 9 kW, bias voltage: -120 V, and substrate temperature: 200°C.

Example 6

A timepiece part (wristwatch case) was produced in the same manner as in Example 5, except that an unpolished SUS444 was used as the substrate (the substrate had a percentage surface area increase of 2.5% relative to the reference flat surface as measured by atomic force microscopy for the surface on which the base layer, the second coating, and the first coating were to be formed), and that the first coating was formed using a different composition for the target CoCrMo alloy used for the formation of the first coating, and was buffed after being formed.

Example 7

First, a pure titanium substrate of a shape corresponding to a wristwatch case was prepared.
The substrate surface (the surface on which the first base layer, the second coating, the second base layer, and the first coating are to be formed) was buffed, and measured with an atomic force microscope. The percentage surface area increase relative to the reference flat surface was 0.7%.
The substrate was washed after the foregoing polishing process. The substrate was washed by being subjected to 30 seconds of alkali electrolytic degreasing, 10 seconds of neutralization, 10 seconds of water washing, and 10 seconds of washing with purified water.
The substrate was then sputtered, and a 0.1 μm-thick first base layer configured from titanium was formed on the substrate surface. The first base layer was formed under the following conditions. Ar gas flow rate: 100 ccm, atmospheric pressure: 0.3 Pa, power: 9 kW, bias voltage: -80 V, substrate temperature: 200°C.
By sputtering, a 0.50 μm-thick second coating configured from TiC was formed on the first base layer surface. The second coating was formed under the following conditions. Ar gas flow rate: 100 ccm, atmospheric pressure: 0.3 Pa, power: 9 kW, bias voltage: -80 V, substrate temperature: 200°C. Here, the flow rate of $C_2H_2$ gas was increased from 10 ccm to 20 ccm, and decreased from 20 ccm to 10 ccm so that the material forming the second coating had a gradient in which the total content of carbon and nitrogen was higher in the vicinity of the center of the second coating in thickness direction, and gradually decreased toward the both surfaces.
By sputtering, a 0.05 μm-thick second base layer configured from titanium was formed on the second coating surface. The second base layer was formed under the following conditions. Ar gas flow rate: 100 ccm, atmospheric pressure: 0.3 Pa, power: 9 kW, bias voltage: -80 V, substrate temperature: 200°C.
By sputtering, a 0.5 μm-thick first coating configured from a CoCrMo alloy was formed on the second base layer surface to obtain a wristwatch case as a timepiece part. The first coating was formed under the following conditions. Ar gas flow rate: 100 ccm, atmospheric pressure: 0.3 Pa, and substrate temperature: 200°C. Here, the power was varied over time from 1 kW to 9 kW, and the bias voltage was varied over time from -80 V to -120 V so that the material forming the first coating had a gradient in which the composition and the film quality gradually varied in thickness direction.

Example 8

A timepiece part (wristwatch case) was produced in the same manner as in Example 7, except that an unpolished SUS444 was used as the substrate (the substrate had a percentage surface area increase of 2.5% relative to the reference flat surface as measured by atomic force microscopy for the surface on which the first base layer, the second coating, the second base layer, and the first coating were to be formed), and that the timepiece part had the configuration shown in the Table 1 below. Specifically, the films (layers) were deposited for different time lengths, and the first coating was buffed after being formed.

Example 9

First, a pure titanium substrate of a shape corresponding to a wristwatch case was prepared.
The substrate surface (the surface on which the first base layer, the second coating, the second base layer, the first coating, and the coating layer are to be formed) was buffed, and measured with an atomic force microscope. The percentage surface area increase relative to the reference flat surface was 0.7%.
The substrate was washed after the foregoing polishing process. The substrate was washed by being subjected to 30 seconds of alkali electrolytic degreasing, 10 seconds of neutralization, 10 seconds of water washing, and 10 seconds of washing with purified water.
The substrate was then sputtered, and a 0.1 μm-thick first base layer configured from titanium was formed on the substrate surface. The first base layer was formed under the following conditions. Ar gas flow rate: 100 ccm, atmospheric pressure: 0.3 Pa, power: 9 kW, bias voltage: -80 V, substrate temperature: 200°C.
By sputtering, a 0.35 μm-thick second coating configured from TiC was formed on the first base layer surface. The second coating was formed under the following conditions. Ar gas flow rate: 100 ccm, flow rate of $C_2H_2$ gas: 22 ccm, atmospheric pressure: 0.3 Pa, power: 9 kW, bias voltage: -80 V, and substrate temperature: 200°C.
By sputtering, a 0.05 μm-thick second base layer configured from titanium was formed on the second coating surface. The second base layer was formed under the following conditions. Ar gas flow rate: 100 ccm, atmospheric pressure: 0.3 Pa, power: 9 kW, bias voltage: -80 V, substrate temperature: 200°C.
By sputtering, a 0.5 μm-thick first coating configured from a CoCrMo alloy was formed on the second base layer surface. The first coating was formed under the following conditions. Ar gas flow rate: 100 ccm, atmospheric pressure: 0.3 Pa, power: 9 kW, bias voltage: -120 V, and substrate temperature: 200°C.
Thereafter, a 0. 03 μm-thick coating layer configured from a fluorine-containing organosilicon compound was

formed on the first coating surface, and a wristwatch case was obtained as a timepiece part.

Specifically, a fluorine-containing organosilicon compound (KY-130(3) available from Shin-Etsu Chemical Co., Ltd.) was diluted with a fluoro solvent (FR thinner available from Shin-Etsu Chemical Co., Ltd.) to make the solid content 3 mass%, and 1.0 g of the solution was charged into a container (cylindrical copper container with an open top; inner diameter 16 mm × inner height 6 mm) that had been charged with 0.5 g of steel wool (Nihon Steel Wool Co., Ltd. ; #0, diameter 0.025 mm), and dried at 120°C for 1 hour. The copper container was then installed in a vacuum evaporator with the substrate provided with the first base layer, the second coating, the second base layer, and the first coating, and the pressure inside the vacuum evaporator was brought to 0.01 Pa. The fluorine-containing organosilicon compound was then evaporated from the copper container so that the film formed at a rate (deposition rate) of 0. 6 Å/s. A molybdenum resistive heating boat was used as a heat source.

Example 10

A timepiece part (wristwatch case) was produced in the same manner as in Example 9, except that an unpolished SUS444 was used as the substrate (the substrate had a percentage surface area increase of 2.5% relative to the reference flat surface as measured by atomic force microscopy for the surface on which the first base layer, the second coating, the second base layer, the first coating, and the coating layer were to be formed), and that the first coating was buffed after being formed.

Comparative Example 1

A timepiece part (wristwatch case) was produced in the same manner as in Example 1, except that a Pt film was formed instead of the first coating configured from a CoCrMo alloy.

Comparative Examples 2 to 5

A timepiece part (wristwatch case) was produced in the same manner as in Example 1, except that a different composition was used for the target CoCrMo alloy used for the formation of the first coating.

Comparative Example 6

A timepiece part (wristwatch case) was produced in the same manner as in Example 1, except that an unpolished pure titanium substrate was used as the substrate (the substrate had a percentage surface area increase of 2.5% relative to the reference flat surface as measured by atomic force microscopy for the surface on which the first coating was to be formed), and that the first coating was formed under the following conditions (settings): Ar gas flow rate: 100 ccm, atmospheric pressure: 3 Pa, power: 1 kW, bias voltage: -60 V, substrate temperature: 120°C.

Comparative Example 7

A timepiece part (wristwatch case) was produced in the same manner as in Example 5, except that an unpolished pure titanium substrate was used as the substrate (the substrate had a percentage surface area increase of 2.5% relative to the reference flat surface as measured by atomic force microscopy for the surface on which the base layer, the second coating, and the first coating were to be formed), and that the second coating was formed under the following conditions (settings) : Ar gas flow rate: 100 ccm, flow rate of $C_2H_2$ gas: 22 ccm, atmospheric pressure: 3 Pa, power: 5 kW, bias voltage: -80 V, substrate temperature: 120°C, and that the first coating was formed under the following conditions. Ar gas flow rate: 100 ccm, atmospheric pressure: 3 Pa, power: 1 kW, bias voltage: -60 V, substrate temperature: 120°C.

Example 11

First, a pure titanium substrate of a shape corresponding to a wristwatch case was prepared.

The substrate surface (the surface on which the first coating is to be formed) was buffed, and subjected to plasma etching. Atomic force microscopy of the surface revealed that the percentage surface area increase relative to the reference flat surface was 2.0%.

The substrate was washed after the foregoing surface treatment (buffing and plasma etching). The substrate was washed by being subjected to 30 seconds of alkali electrolytic degreasing, 10 seconds of neutralization, 10 seconds of water washing, and 10 seconds of washing with purified water.

The substrate was then sputtered, and a 0.5 μm-thick first coating configured from a CoCrMo alloy was formed on the substrate surface to obtain a wristwatch case as a timepiece part. The first coating was formed under the following

conditions. Ar gas flow rate: 100 ccm, atmospheric pressure: 3 Pa, power: 1 kW, bias voltage: -60 V, and substrate temperature: 120°C.

Atomic force microscopy revealed that the surface of the first coating (second surface) had a percentage surface area increase of 2.5% relative to the reference flat surface.

Example 12

A timepiece part (wristwatch case) was produced in the same manner as in Example 11, except that a ferrite stainless steel SUS444 with no surface treatment (e.g., polishing, and roughening) was used as the substrate (the substrate had a percentage surface area increase of 2.5% relative to the reference flat surface as measured by atomic force microscopy for the surface on which the first coating was to be formed), and that the first coating was subjected to buffing and plasma etching in this order.

Example 13

First, a pure titanium substrate of a shape corresponding to a wristwatch case was prepared.

The substrate surface (the surface on which the base layer and the first coating are to be formed) was buffed, and subjected to plasma etching. Atomic force microscopy of the surface revealed that the percentage surface area increase relative to the reference flat surface was 2.0%.

The substrate was washed after the foregoing surface treatment (buffing and plasma etching). The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick base layer (first base layer) configured from titanium was formed on the substrate surface. The base layer was formed under the following conditions. Ar gas flow rate: 100 ccm, atmospheric pressure: 3 Pa, power: 1 kW, bias voltage: -60 V, and substrate temperature: 120°C.

By sputtering, a 0.5 μm-thick first coating configured from a CoCrMo alloy was formed on the base layer surface to obtain a wristwatch case as a timepiece part. The first coating was formed under the following conditions. Ar gas flow rate: 100 ccm, atmospheric pressure: 3 Pa, power: 1 kW, bias voltage: -60 V, and substrate temperature: 120°C.

Example 14

A timepiece part (wristwatch case) was produced in the same manner as in Example 13, except that a SUS444 with no surface treatment (e.g., polishing, and roughening) was used as the substrate (the substrate had a percentage surface area increase of 2.5% relative to the reference flat surface as measured by atomic force microscopy for the surface on which the base layer and the first coating were to be formed), and that a different composition was used for the target CoCrMo alloy used for the formation of the first coating, and the first coating formed was subjected to buffing and plasma etching in this order.

Example 15

First, a pure titanium substrate of a shape corresponding to a wristwatch case was prepared.

The substrate surface (the surface on which the base layer, the second coating, and the first coating are to be formed) was buffed, and subjected to plasma etching. Atomic force microscopy of the surface revealed that the percentage surface area increase relative to the reference flat surface was 2.0%.

The substrate was washed after the foregoing surface treatment (buffing and plasma etching). The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick base layer configured from titanium was formed on the substrate surface. The base layer was formed under the following conditions. Ar gas flow rate: 100 ccm, atmospheric pressure: 3 Pa, power: 1 kW, bias voltage: -60 V, and substrate temperature: 120°C.

By sputtering, a 0.35 μm-thick second coating configured from TiC was formed on the base layer surface. The second coating was formed under the following conditions. Ar gas flow rate: 100 ccm, flow rate of $C_2H_2$ gas : 22 ccm, atmospheric pressure: 3 Pa, power: 5 kW, bias voltage: -80 V, and substrate temperature: 120°C.

By sputtering, a 0.5 μm-thick first coating configured from a CoCrMo alloy was formed on the second coating surface to obtain a wristwatch case as a timepiece part. The first coating was formed under the following conditions. Ar gas flow rate: 100 ccm, atmospheric pressure: 3 Pa, power: 1 kW, bias voltage: -60 V, and substrate temperature: 120°C.

Example 16

A timepiece part (wristwatch case) was produced in the same manner as in Example 15, except that a SUS444 with no surface treatment (e.g., polishing, and roughening) was used as the substrate (the substrate had a percentage surface area increase of 2.5% relative to the reference flat surface as measured by atomic force microscopy for the surface on which the base layer, the second coating, and the first coating were to be formed), and that the first coating was formed using a different composition for the target CoCrMo alloy used for the formation of the first coating, and was subjected to buffing and plasma etching in this order.

Example 17

First, a pure titanium substrate of a shape corresponding to a wristwatch case was prepared.

The substrate surface (the surface on which the first base layer, the second coating, the second base layer, and the first coating are to be formed) was buffed, and subjected to plasma etching. Atomic force microscopy of the surface revealed that the percentage surface area increase relative to the reference flat surface was 2.0%.

The substrate was washed after the foregoing surface treatment (buffing and plasma etching). The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick first base layer configured from titanium was formed on the substrate surface. The first base layer was formed under the following conditions. Ar gas flow rate: 100 ccm, atmospheric pressure: 3 Pa, power: 1 kW, bias voltage: -60 V, and substrate temperature: 120°C.

By sputtering, a 0.50 μm-thick second coating configured from TiC was formed on the first base layer surface. The second coating was formed under the following conditions. Ar gas flow rate: 100 ccm, atmospheric pressure: 3 Pa, power: 5 kW, bias voltage: -80 V, and substrate temperature: 120°C. Here, the flow rate of $C_2H_2$ gas was increased from 10 ccm to 20 ccm, and decreased from 20 ccm to 10 ccm so that the material forming the second coating had a gradient in which the total content of carbon and nitrogen was higher in the vicinity of the center of the second coating in thickness direction, and gradually decreased toward the both surfaces.

By sputtering, a 0.05 μm-thick second base layer configured from titanium was formed on the second coating surface. The second base layer was formed under the following conditions. Ar gas flow rate: 100 ccm, atmospheric pressure: 3 Pa, power: 1 kW, bias voltage: -60 V, and substrate temperature: 120°C.

By sputtering, a 0.5 μm-thick first coating configured from a CoCrMo alloy was formed on the second base layer surface to obtain a wristwatch case as a timepiece part. The first coating was formed under the following conditions. Ar gas flow rate: 100 ccm, atmospheric pressure: 3 Pa, and substrate temperature: 120°C. Here, the power was varied over time from 0.5 kW to 2 kW, and the bias voltage was varied over time from -40 V to -80 V so that the material forming the first coating had a gradient in which the composition and the film quality gradually varied in thickness direction.

Example 18

A timepiece part (wristwatch case) was produced in the same manner as in Example 17, except that a SUS444 with no surface treatment (e.g., polishing, and roughening) was used as the substrate (the substrate had a percentage surface area increase of 2.5% relative to the reference flat surface as measured by atomic force microscopy for the surface on which the first base layer, the second coating, the second base layer, and the first coating were to be formed), and that the timepiece part had the configuration shown in Table 1. Specifically, the films (layers) were deposited for different time lengths, and the first coating formed was subjected to buffing and plasma etching in this order.

Example 19

First, a pure titanium substrate of a shape corresponding to a wristwatch case was prepared.

The substrate surface (the surface on which the first base layer, the second coating, the second base layer, the first coating, and the coating layer are to be formed) was buffed, and subjected to plasma etching. Atomic force microscopy of the surface revealed that the percentage surface area increase relative to the reference flat surface was 2.0%.

The substrate was washed after the foregoing surface treatment (buffing and plasma etching). The substrate was washed by being subjected to 30 seconds of alkali electrolytic degreasing, 10 seconds of neutralization, 10 seconds of water washing, and 10 seconds of washing with purified water.

The substrate was then sputtered, and a 0.1 μm-thick first base layer configured from titanium was formed on the substrate surface. The first base layer was formed under the following conditions. Ar gas flow rate: 100 ccm, atmospheric pressure: 3 Pa, power: 1 kW, bias voltage: -60 V, and substrate temperature: 120°C.

By sputtering, a 0.35 μm-thick second coating configured from TiC was formed on the first base layer surface. The second coating was formed under the following conditions. Ar gas flow rate: 100 ccm, flow rate of $C_2H_2$ gas: 22 ccm, atmospheric pressure: 3 Pa, power: 5 kW, bias voltage: -80 V, and substrate temperature: 120°C.

By sputtering, a 0.05 μm-thick second base layer configured from titanium was formed on the second coating surface. The second base layer was formed under the following conditions. Ar gas flow rate: 100 ccm, atmospheric pressure: 3 Pa, power: 1 kW, bias voltage: -60 V, and substrate temperature: 120°C.

By sputtering, a 0.5 μm-thick first coating configured from a CoCrMo alloy was formed on the second base layer surface. The first coating was formed under the following conditions. Ar gas flow rate: 100 ccm, atmospheric pressure: 3 Pa, power: 1 kW, bias voltage: -60 V, and substrate temperature: 120°C.

Thereafter, a 0.03 μm-thick coating layer configured from a fluorine-containing organosilicon compound was formed on the first coating surface, and a wristwatch case was obtained as a timepiece part.

Specifically, a fluorine-containing organosilicon compound (KY-130(3) available from Shin-Etsu Chemical Co., Ltd.) was diluted with a fluoro solvent (FR thinner available from Shin-Etsu Chemical Co., Ltd.) to make the solid content 3 mass%, and 1.0 g of the solution was charged into a container (cylindrical copper container with an open top; inner diameter 16 mm × inner height 6 mm) that had been charged with 0.5 g of steel wool (Nihon Steel Wool Co., Ltd. ; #0, diameter 0.025 mm), and dried at 120°C for 1 hour. The copper container was then installed in a vacuum evaporator with the substrate provided with the first base layer, the second coating, the second base layer, and the first coating, and the pressure inside the vacuum evaporator was brought to 0.01 Pa. The fluorine-containing organosilicon compound was then evaporated from the copper container so that the film formed at a rate (deposition rate) of 0.6 Å/s. A molybdenum resistive heating boat was used as a heat source.

Example 20

A timepiece part (wristwatch case) was produced in the same manner as in Example 19, except that a SUS444 with no surface treatment (e.g., polishing, and roughening) was used as the substrate (the substrate had a percentage surface area increase of 2.5% relative to the reference flat surface as measured by atomic force microscopy for the surface on which the first base layer, the second coating, the second base layer, the first coating, and the coating layer were to be formed), and that the first coating formed was subjected to buffing and plasma etching in this order.

Comparative Example 8

A timepiece part (wristwatch case) was produced in the same manner as in Example 11, except that a Pt film was formed instead of the first coating configured from a CoCrMo alloy.

Comparative Examples 9 to 12

A timepiece part (wristwatch case) was produced in the same manner as in Example 11, except that a different composition was used for the target CoCrMo alloy used for the formation of the first coating.

Comparative Example 13

A timepiece part (wristwatch case) was produced in the same manner as in Example 11, except that a pure titanium substrate that had been subjected to buffing without plasma etching was used as the substrate (the substrate had a percentage surface area increase of 0.7% relative to the reference flat surface as measured by atomic force microscopy for the surface on which the first coating was to be formed), and that the first coating was formed under the following settings. Ar gas flow rate: 100 ccm, atmospheric pressure: 0.3 Pa, power: 9 kW, bias voltage: -120 V, and substrate temperature: 200°C.

Comparative Example 14

A timepiece part (wristwatch case) was produced in the same manner as in Example 15, except that a pure titanium substrate that had been subjected to buffing without plasma etching was used as the substrate (the substrate had a percentage surface area increase of 0.7% relative to the reference flat surface as measured by atomic force microscopy for the surface on which the base layer, the second coating, and the first coating were to be formed), and that the second coating was formed under the following conditions (settings) . Ar gas flow rate: 100 ccm, flow rate of $C_2H_2$ gas: 22 ccm, atmospheric pressure: 0.3 Pa, power: 9 kW, bias voltage: -80 V, substrate temperature: 200°C, and the first coating was formed under the following conditions (settings). Ar gas flow rate: 100 ccm, atmospheric pressure: 0.3 Pa, power: 9 kW, bias voltage: -120 V, substrate temperature: 200°C.

Comparative Example 15

A timepiece part (wristwatch case) was produced in the same manner as in Example 11, except that a pure titanium substrate with no surface treatment (e.g., polishing, roughening) was used as the substrate (the substrate had a percentage surface area increase of 2.5% relative to the reference flat surface as measured by atomic force microscopy for the surface on which the first coating was to be formed), and that the first coating was formed under the following conditions (settings). Ar gas flow rate: 150 ccm, atmospheric pressure: 5 Pa, power: 1 kW, bias voltage: -50 V, substrate temperature: 100°C.

Comparative Example 16

A timepiece part (wristwatch case) was produced in the same manner as in Example 15, except that a pure titanium substrate with no surface treatment (e.g., polishing, roughening) was used as the substrate (the substrate had a percentage surface area increase of 2.5% relative to the reference flat surface as measured by atomic force microscopy for the surface on which the base layer, the second coating, and the first coating were to be formed), and that the second coating was formed under the following conditions (settings) . Ar gas flow rate: 150 ccm, flow rate of $C_2H_2$ gas: 30 ccm, atmospheric pressure: 4.5 Pa, power: 3 kW, bias voltage: -80 V, substrate temperature: 100°C, and that the first coating was formed under the following conditions. Ar gas flow rate: 150 ccm, atmospheric pressure: 5 Pa, power: 1 kw, bias voltage: -50 V, substrate temperature: 100°C.

Tables 1 and 2 below summarize the configurations of the timepiece parts of Examples and Comparative Examples. For Comparative Examples 1 and 8, the Pt film condition is shown under the heading "First coating". The content of the first-coating components other than those shown in Tables 1 and 2 (the total content of more than one component) is 1.5 mass% or less in all of Examples and Comparative Examples. The contents of the components shown in the tables are all 99.9 mass% or more in different constituting members of the timepiece part.

Table 1

| | Substrate | First base layer | | Second coating | | Second base layer | |
|---|---|---|---|---|---|---|---|
| | Constituent material | Constituent material | Thickness (μm) | Constituent material | Thickness (μm) | Constituent material | Thickness (μm) |
| Example 1 | Ti | - | - | - | - | - | - |
| Example 2 | SUS444 | - | - | - | - | - | - |
| Example 3 | Ti | Ti | 0.1 | - | - | - | - |
| Example 4 | SUS444 | Ti | 0.1 | - | - | - | - |
| Example 5 | Ti | Ti | 0.1 | TiC | 0.35 | - | - |
| Example 6 | SUS444 | Ti | 0.1 | TiC | 0.35 | - | - |
| Example 7 | Ti | Ti | 0.1 | TiC | 0.50 | Ti | 0.05 |
| Example 8 | SUS444 | Ti | 0.3 | TiC | 0.85 | Ti | 0.2 |
| Example 9 | Ti | Ti | 0.1 | TiC | 0.35 | Ti | 0.05 |
| Example 10 | SUS444 | Ti | 0.1 | TiC | 0.35 | Ti | 0.05 |
| Comparative Example 1 | Ti | - | - | - | - | - | - |
| Comparative Example 2 | Ti | - | - | - | - | - | - |
| Comparative Example 3 | Ti | - | - | - | - | - | - |
| Comparative Example 4 | Ti | - | - | - | - | - | - |
| Comparative Example 5 | Ti | - | - | - | - | - | - |
| Comparative Example 6 | Ti | - | - | - | - | - | - |
| Comparative Example 7 | Ti | Ti | 0.1 | TiC | 0.35 | - | - |

Table 1 (Continued)

| | First coating | | | | | | Coating layer | |
|---|---|---|---|---|---|---|---|---|
| | Constituent material | | | | Thickness (μm) | Percentage surface area increase of surface (second surface) (%) | Constituent material | Thickness (μm) |
| | Co content (mass%) | Cr content (mass%) | Mo content (mass%) | Pt content (mass%) | | | | |
| Example 1 | Bal. | 28.2 | 6.0 | 0 | 0.5 | 0.7 | - | - |
| Example 2 | Bal. | 28.2 | 6.0 | 0 | 0.5 | 1.1 | - | - |
| Example 3 | Bal. | 26.6 | 6.2 | 0 | 0.5 | 0.6 | - | - |
| Example 4 | Bal. | 29.4 | 5.5 | 0 | 0.5 | 1.0 | - | - |
| Example 5 | Bal. | 28.8 | 5.4 | 0 | 0.5 | 0.8 | - | - |
| Example 6 | Bal. | 27.7 | 6.6 | 0 | 0.5 | 1.2 | - | - |
| Example 7 | Bal. | 28.2 | 6.0 | 0 | 0.5 | 0.7 | - | - |
| Example 8 | Bal. | 28.5 | 5.8 | 0 | 1.0 | 1.1 | - | - |
| Example 9 | Bal. | 28.1 | 6.1 | 0 | 0.5 | 0.7 | Fluorine-containing organosilicon compound | 0.03 |
| Example 10 | Bal. | 28.1 | 6.1 | 0 | 0.5 | 1.0 | Fluorine-containing organosilicon compound | 0.03 |
| Comparative Example 1 | 0 | 0 | 0 | 100 | 0.5 | 0.7 | - | - |
| Comparative Example 2 | Bal. | 26.1 | 6.0 | 0 | 0.5 | 0.7 | - | - |
| Comparative Example 3 | Bal. | 30.3 | 6.0 | 0 | 0.5 | 0.7 | - | - |
| Comparative Example 4 | Bal. | 28.2 | 4.8 | 0 | 0.5 | 0.7 | - | - |
| Comparative Example 5 | Bal. | 28.2 | 7.2 | 0 | 0.5 | 0.7 | - | - |
| Comparative Example 6 | Bal. | 28.2 | 6.0 | 0 | 0.5 | 2.0 | - | - |
| Comparative Example 7 | Bal. | 28.8 | 5.4 | 0 | 0.5 | 1.5 | - | - |

Table 2

| | Substrate | First base layer | | Second coating | | Second base layer | |
|---|---|---|---|---|---|---|---|
| | Constituent material | Constituent material | Thickness (μm) | Constituent material | Thickness (μm) | Constituent material | Thickness (μm) |
| Example 11 | Ti | - | - | - | - | - | - |
| Example 12 | SUS444 | - | - | - | - | - | - |
| Example 13 | Ti | Ti | 0.1 | - | - | - | - |
| Example 14 | SUS444 | Ti | 0.1 | - | - | - | - |
| Example 15 | Ti | Ti | 0.1 | TiC | 0.35 | - | - |
| Example 16 | SUS444 | Ti | 0.1 | TiC | 0.35 | - | - |
| Example 17 | Ti | Ti | 0.1 | TiC | 0.50 | Ti | 0.05 |
| Example 18 | SUS444 | Ti | 0.3 | TiC | 0.85 | Ti | 0.2 |
| Example 19 | Ti | Ti | 0.1 | TiC | 0.35 | Ti | 0.05 |
| Example 20 | SUS444 | Ti | 0.1 | TiC | 0.35 | Ti | 0.05 |
| Comparative Example 8 | Ti | - | - | - | - | - | - |
| Comparative Example 9 | Ti | - | - | - | - | - | - |
| Comparative Example 10 | Ti | - | - | - | - | - | - |
| Comparative Example 11 | Ti | - | - | - | - | - | - |
| Comparative Example 12 | Ti | - | - | - | - | - | - |
| Comparative Example 13 | Ti | - | - | - | - | - | - |
| Comparative Example 14 | Ti | Ti | 0.1 | TiC | 0.35 | - | - |
| Comparative Example 15 | Ti | - | - | - | - | - | - |
| Comparative Example 16 | Ti | Ti | 0.1 | TiC | 0.35 | - | - |

Table 2 (Continued)

| | First coating | | | | | | Coating layer | |
|---|---|---|---|---|---|---|---|---|
| | Constituent material | | | | Thickness (μm) | Percentage surface area increase of surface (second surface) (%) | Constituent material | Thickness (μm) |
| | Co content (mass%) | Cr content (mass%) | Mo content (mass%) | Pt content (mass%) | | | | |
| Example 11 | Bal. | 28.2 | 6.0 | 0 | 0.5 | 2.5 | - | - |
| Example 12 | Bal. | 28.2 | 6.0 | 0 | 0.5 | 2.1 | - | - |
| Example 13 | Bal. | 26.6 | 6.2 | 0 | 0.5 | 2.6 | - | - |
| Example 14 | Bal. | 29.4 | 5.5 | 0 | 0.5 | 2.9 | - | - |
| Example 15 | Bal. | 28.8 | 5.4 | 0 | 0.5 | 1.8 | - | - |
| Example 16 | Bal. | 27.7 | 6.6 | 0 | 0.5 | 2.0 | - | - |
| Example 17 | Bal. | 28.2 | 6.0 | 0 | 0.5 | 2.3 | - | - |
| Example 18 | Bal. | 28.5 | 5.8 | 0 | 1.0 | 2.6 | - | - |
| Example 19 | Bal. | 28.1 | 6.1 | 0 | 0.5 | 2.2 | Fluorine-containing organosilicon compound | 0.03 |
| Example 20 | Bal. | 28.1 | 6.1 | 0 | 0.5 | 2.4 | Fluorine-containing organosilicon compound | 0.03 |
| Comparative Example 8 | 0 | 0 | 0 | 100 | 0.5 | 2.5 | - | - |
| Comparative Example 9 | Bal. | 26.1 | 6.0 | 0 | 0.5 | 2.5 | - | - |
| Comparative Example 10 | Bal. | 30.3 | 6.0 | 0 | 0.5 | 2.5 | - | - |
| Comparative Example 11 | Bal. | 28.2 | 4.8 | 0 | 0.5 | 2.5 | - | - |
| Comparative Example 12 | Bal. | 28.2 | 7.2 | 0 | 0.5 | 2.5 | - | - |
| Comparative Example 13 | Bal. | 28.2 | 6.0 | 0 | 0.5 | 0.7 | - | - |
| Comparative Example 14 | Bal. | 28.8 | 5.4 | 0 | 0.5 | 0.9 | - | - |
| Comparative Example 15 | Bal. | 28.2 | 6.0 | 0 | 0.5 | 5.2 | - | - |
| Comparative Example 16 | Bal. | 28.8 | 5.4 | 0 | 0.5 | 5.5 | - | - |

2. Evaluation

2-1. Evaluation of External Appearance by Visual Inspection

The timepiece parts produced in Examples and Comparative Examples were visually inspected, and evaluated according to the following criteria.

Examples 1 to 10, and Comparative Examples 1 to 7

A: An exceptional external appearance with a very luxurious, glossy look.
B: A superb external appearance with a luxurious, glossy look.
C: A desirable external appearance with a luxurious, glossy look.
D: A moderate external appearance lacking sufficient gloss.
E: A poor external appearance with low gloss.

Examples 10 to 20, and Comparative Examples 8 to 16

A: An exceptional external appearance having a not-too-bright luxurious look creating a subdued impression with moderate gloss.
B: A superb external appearance having a not-too-bright luxurious look creating a subdued impression with moderate gloss.
C: A desirable external appearance having a not-too-bright luxurious look creating a subdued impression with moderate gloss.
D: A moderate external appearance that is too bright or lacking sufficient gloss.
E: A poor external appearance with low gloss or extremely high brightness.

2-2. Spectrophotometric Evaluation of External Appearance

2-2-1. Evaluation of L* Value

The timepiece parts produced in Examples and Comparative Examples were measured with a spectrophotometer (Konica Minolta, CM-5), and evaluated according to the following criteria.

Examples 1 to 10, and Comparative Examples 1 to 7

A: L* value is 82.0 to 88.0 in an L*a*b* chromaticity diagram according to the JIS Z 8729 specification.
B: L* value is 80.0 to 88.5 in an L*a*b* chromaticity diagram according to the JIS Z 8729 specification (excluding the range specified in A).
C: L* value is 78.5 to 89.0 in an L*a*b* chromaticity diagram according to the JIS Z 8729 specification (excluding the ranges specified in A and B).
D: L* value is 74.0 or more and less than 78.5 in an L*a*b* chromaticity diagram according to the JIS Z 8729 specification.
E: L* value is more than 89.0 or less than 74.0 in an L*a*b* chromaticity diagram according to the JIS Z 8729 specification.

Examples 10 to 20, and Comparative Examples 8 to 16

A: L* value is 74.0 to 78.2 in an L*a*b* chromaticity diagram according to the JIS Z 8729 specification.
B: L* value is 72.0 to 78.3 in an L*a*b* chromaticity diagram according to the JIS Z 8729 specification (excluding the range specified in A).

C: L* value is 70.0 to 78.4 in an L*a*b* chromaticity diagram according to the JIS Z 8729 specification (excluding the ranges specified in A and B).
D: L* value is 68.0 to 80 in an L*a*b* chromaticity diagram according to the JIS Z 8729 specification (excluding the ranges specified in A, B, and C).
E: L* value is outside the range of 68. 0 to 80 in an L*a*b* chromaticity diagram according to the JIS Z 8729 specification.

For the spectrophotometry, the light source D65 specified by JIS Z 8720 was used at a viewing angle of 2°.

2-2-2. Evaluation of a* and b* Values

The timepiece parts produced in Examples and Comparative Examples were measured with a spectrophotometer (Konica Minolta, CM-5), and evaluated according to the following criteria.

A: a* value is -1.0 to 2.0, and b* value is 1.0 to 8.0 in an L*a*b* chromaticity diagram according to the JIS Z 8729 specification.
B: a* value is -1.5 to 2.5, and b* value is 0.0 to 9.0 in an L*a*b* chromaticity diagram according to the JIS Z 8729 specification (excluding the range specified in A).
C: a* value is -2.0 to 3.0, and b* value is -1.0 to 10.0 in an L*a*b* chromaticity diagram according to the JIS Z 8729 specification (excluding the ranges specified in A and B).
D: a* value is -3.0 to 4.0, and b* value is -2.0 to 11.0 in an L*a*b* chromaticity diagram according to the JIS Z 8729 specification (excluding the ranges specified in A, B, and C).
E: a* value is outside the range of -3.0 to 4.0, and b* value is outside the range of -2.0 to 11.0 in an L*a*b* chromaticity diagram according to the JIS Z 8729 specification.

For the spectrophotometry, the light source D65 specified by JIS Z 8720 was used at a viewing angle of 2°.

2-3. Evaluation of Corrosion Resistance

Artificial sweat was placed in a desiccator, and allowed to stand at 45°C for 12 hours. The timepiece parts were separately placed in the desiccator, and allowed to stand at 45°C. Here, the timepiece part was disposed without being immersed in the artificial sweat. After 120 hours, the timepiece part was taken out of the desiccator, and measured for color tone using a spectrophotometer (Konica Minolta, CM-5). The color difference before and after the aeration test was then determined, and evaluated according to the following criteria.

A: The color difference ΔE is less than 3.
B: The color difference ΔE is 3 or more and less than 4.
C: The color difference ΔE is 4 or more and less than 5.
D: The color difference ΔE is 5 or more and less than 6.
E: The color difference ΔE is 6 or more.

For the spectrophotometry, the light source D65 specified by JIS Z 8720 was used at a viewing angle of 2°.

2-4. Evaluation of Abrasion Resistance and Wear Resistance

The timepiece parts produced in Examples and Comparative Examples were tested and evaluated for abrasion resistance and wear resistance, as follows.
The surface of the timepiece part was abrased under a load of 200 gf in a total of 300 DS (double strokes) using a Suga abrasion tester (Suga Test Instruments Co., Ltd., NUS-ISO-1) . The external appearance of the timepiece part was visually inspected, and evaluated according to the following criteria. The test was conducted using a lapping film (aluminum oxide, grain size: 30 μm) available from Sumitomo 3M.

A: No surface scratch at all.
B: Hardly any surface scratch is recognizable.
C: Only a few surface scratches are recognizable.
D: Many surface scratches are recognizable, or there is coating detachment (e.g., the first coating, the coating layer).

2-5. Evaluation of Dent Resistance

The timepiece parts produced in Examples and Comparative Examples were tested and evaluated for dent resistance, as follows.

A stainless steel ball (diameter: 1 cm) was dropped onto a specific location of the timepiece part from a height of 100 cm. The size of the dent formed on the timepiece part surface (the diameter of the indentation) was then measured, and evaluated according to the following criteria.

A: Indentation has a diameter of less than 0.5 mm, or unmeasurable.

B: Indentation has a diameter of 0.5 mm or more and less than 1.0 mm.

C: Indentation has a diameter of 1.0 mm or more and less than 1.5 mm.

D: Indentation has a diameter of 1.5 mm or more.

The results are summarized in Tables 3 and 4.

Table 3

| | Evaluation of external appearance by visual inspection | Colorimetric evaluation of external appearance | | Evaluation of corrosion resistance | Evaluation of abrasion resistance and wear resistance | Evaluation of dent resistance |
|---|---|---|---|---|---|---|
| | | L* | a* and b* | | | |
| Example 1 | A | A | A | A | B | B |
| Example 2 | A | B | A | A | B | B |
| Example 3 | A | A | A | A | B | B |
| Example 4 | A | B | A | A | B | B |
| Example 5 | A | A | A | A | A | A |
| Example 6 | A | B | A | A | A | A |
| Example 7 | A | A | A | A | A | A |
| Example 8 | A | B | A | A | A | A |
| Example 9 | A | A | A | A | A | A |
| Example 10 | A | B | A | A | A | A |
| Comparative Example 1 | A | A | A | A | D | D |
| Comparative Example 2 | A | A | A | E | D | D |
| Comparative Example 3 | D | D | A | A | A | A |
| Comparative Example 4 | A | A | A | A | C | C |
| Comparative Example 5 | D | D | A | A | A | A |
| Comparative Example 6 | D | D | A | A | B | B |
| Comparative Example 7 | D | D | A | A | A | A |

Table 4

| | Evaluation of external appearance by visual inspection | Colorimetric evaluation of external appearance | | Evaluation of corrosion resistance | Evaluation of abrasion resistance and wear resistance | Evaluation of dent resistance |
|---|---|---|---|---|---|---|
| | | L* | a* and b* | | | |
| Example 11 | A | A | A | A | B | B |
| Example 12 | A | A | A | A | B | B |
| Example 13 | A | A | A | A | B | B |
| Example 14 | A | A | A | A | B | B |
| Example 15 | A | A | A | A | A | A |
| Example 16 | A | A | A | A | A | A |
| Example 17 | A | A | A | A | A | A |
| Example 18 | A | A | A | A | A | A |
| Example 19 | A | A | A | A | A | A |
| Example 20 | A | A | A | A | A | A |
| Comparative Example 8 | A | A | A | A | D | D |
| Comparative Example 9 | A | A | A | E | D | D |
| Comparative Example 10 | D | D | A | A | A | A |
| Comparative Example 11 | A | A | A | A | C | C |
| Comparative Example 12 | D | D | A | A | A | A |
| Comparative Example 13 | D | D | A | A | B | B |
| Comparative Example 14 | D | D | A | A | A | A |
| Comparative Example 15 | D | D | A | A | B | B |
| Comparative Example 16 | D | D | A | A | A | A |

As is clear from Tables 3 and 4, the results were desirable for the timepiece parts according to the invention. The timepiece parts according to the invention also did not produce an allergic reaction in a patch test conducted according to the ICDRG standards. Elution of a component that causes an allergic reaction was not observed in an elution test conducted with artificial sweat according to JCWA-T003, EN1811. In contrast, the results were unsatisfactory in Comparative Examples. The timepiece parts of Examples 9, 10, 19, and 20, which had the coating layer configured from a material containing a fluorine-containing organosilicon compound, were particularly desirable in terms of anti-staining property, and texture.

The same results were obtained in evaluations conducted in the same fashion for timepiece parts (bands) produced in the same manner as in the foregoing Examples and Comparative Examples, except that the substrate had a band shape.

The results were also the same in evaluations conducted in the same fashion for timepiece parts produced in the same manner as in Examples 5 to 10, and 15 to 20, except that the second coating was formed of TiCN, instead of TiC.

The timepiece parts produced in Examples and Comparative Examples were also used to assemble a wristwatch

as shown in FIG. 11. Evaluations of the wristwatches also produced the same results.

## Claims

1. A timepiece part comprising:

   a substrate; and
   a first coating configured from a material comprising cobalt as a primary component, and 26 mass% to 30 mass% of Cr, and 5 mass% to 7 mass% of Mo,
   the first coating having a surface with a percentage surface area increase of either (i) 0% to 1.2%or (ii) of 1.5% to 5.0%, in each case as measured against a reference flat surface.

2. The timepiece part according to claim 1, wherein the percentage surface area increase is 0% to 1.2%, and wherein the first coating has an L* value of 78.5 to 89.0 in an L*a*b* chromaticity diagram as measured according to the JIS Z 8729 specification for a surface on a viewing side of the first coating.

3. The timepiece part according to claim 1, wherein the percentage surface area increase is 1.5% to 2.0%, and wherein the first coating which has an L* value of 70.0 to 78.4 in an L*a*b* chromaticity diagram as measured according to the JIS Z 8729 specification for a surface on a viewing side of the first coating.

4. The timepiece part according to any preceding claim, wherein the substrate is configured from a material containing at least one of stainless steel, and titanium.

5. The timepiece part according to any preceding claim, wherein at least one base layer configured from a titanium-containing material is provided between the substrate and the first coating.

6. The timepiece part according to any preceding claim, wherein a second coating configured from a material containing at least one of TiC and TiCN is provided between the substrate and the first coating.

7. The timepiece part according to claim 5,
   wherein a second coating configured from a material containing at least one of TiC and TiCN is provided between the substrate and the first coating, and
   wherein the base layer is provided on both sides of the second coating.

8. The timepiece part according to claim 6 or claim 7, wherein the second coating has a portion where the composition gradually varies in the thickness direction.

9. The timepiece part according to claim 6 or claim 7, wherein the second coating has a region where a total content of carbon and nitrogen decreases toward a surface of the second coating.

10. The timepiece part according to claim 9, wherein the second coating has the region toward both surfaces of the second coating.

11. The timepiece part according to any of claims 6-10, wherein the second coating has a thickness of 0.05 μm to 4.0 μm.

12. The timepiece part according to claim 3, wherein the first coating has a thickness of 0.02 μm to 2.0 μm.

13. The timepiece part according to any of claims 6-10, wherein the timepiece part is a case or a band.

14. A timepiece comprising the timepiece part of any preceding claim.

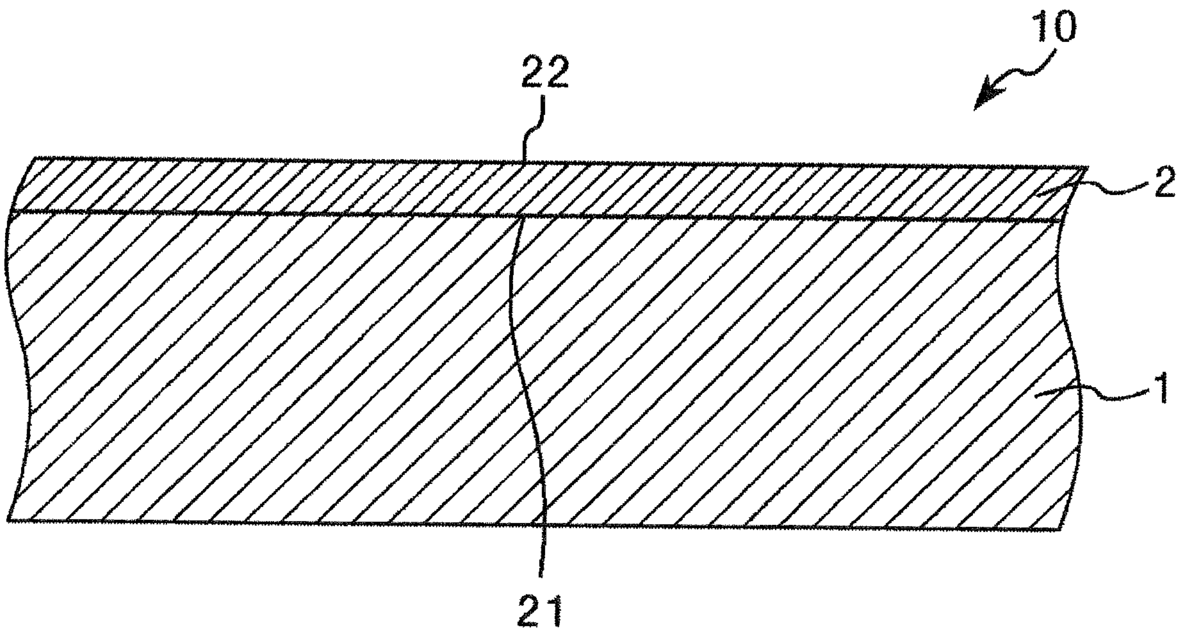


FIG. 1

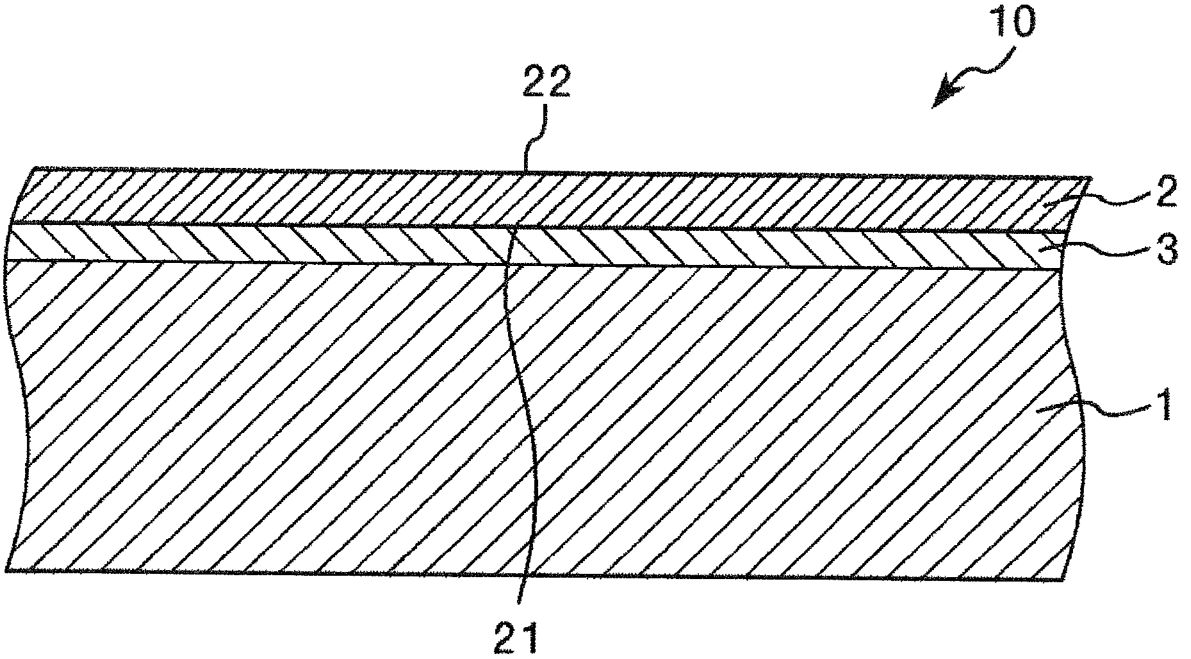


FIG. 2

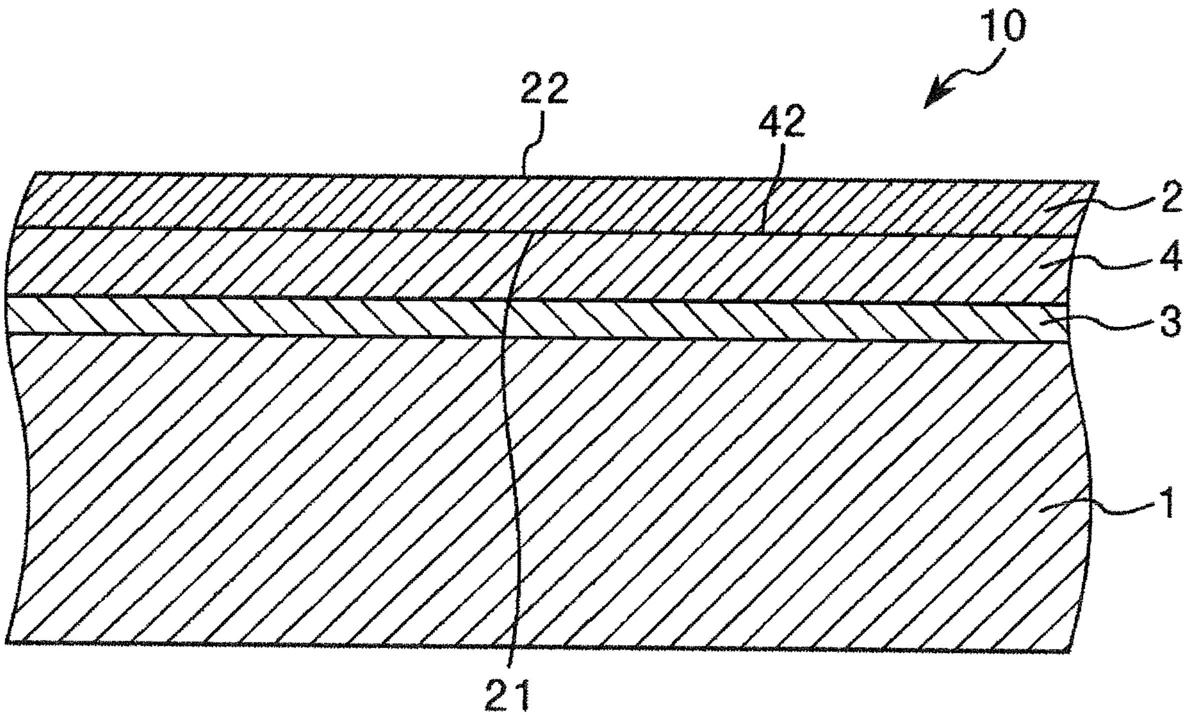


FIG. 3

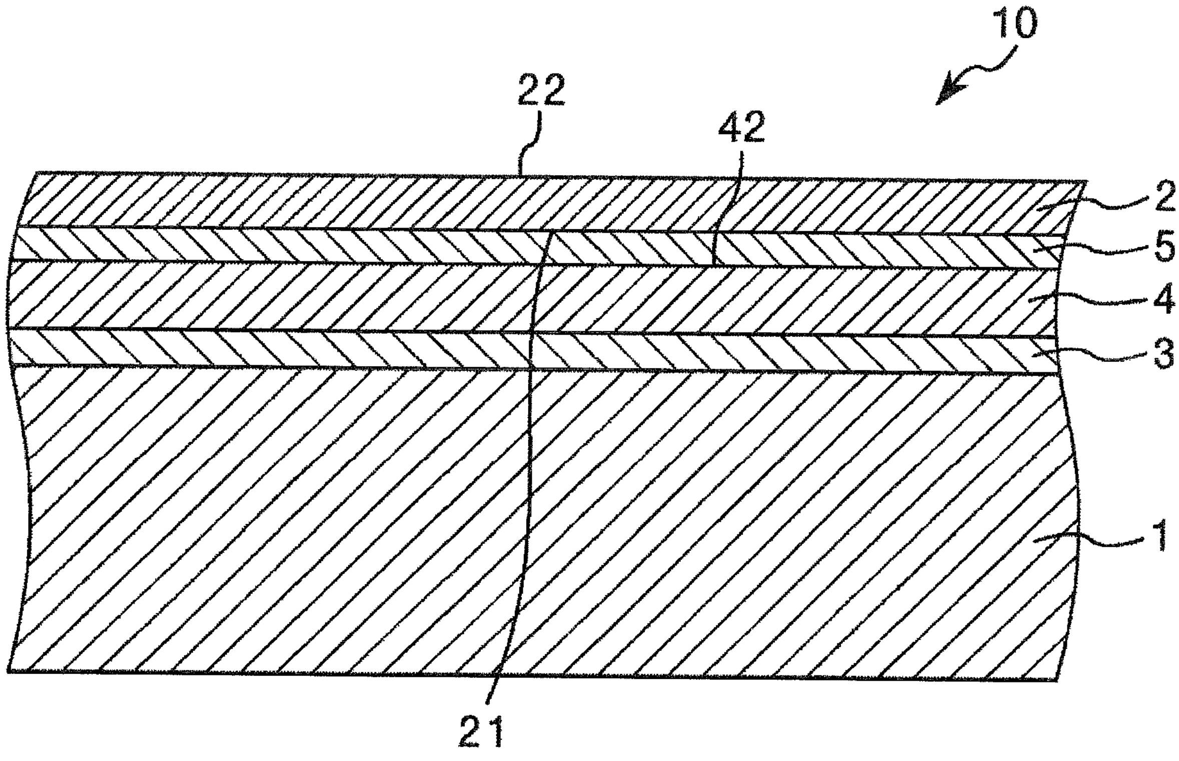


FIG. 4

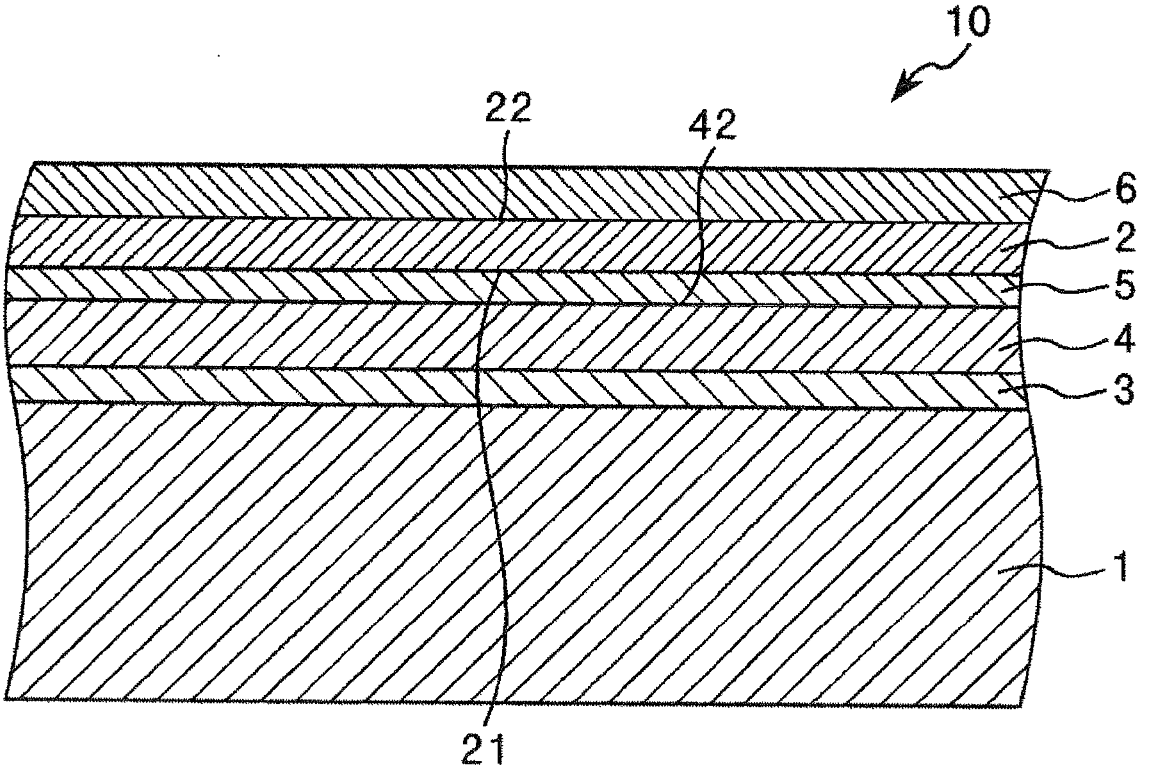


FIG. 5

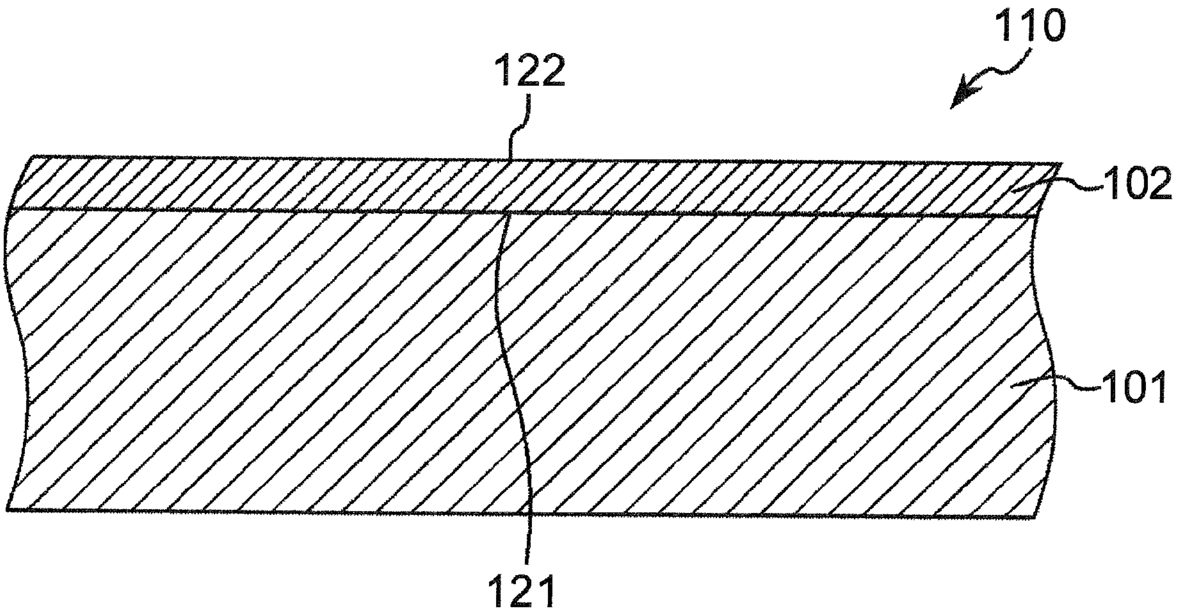


FIG. 6

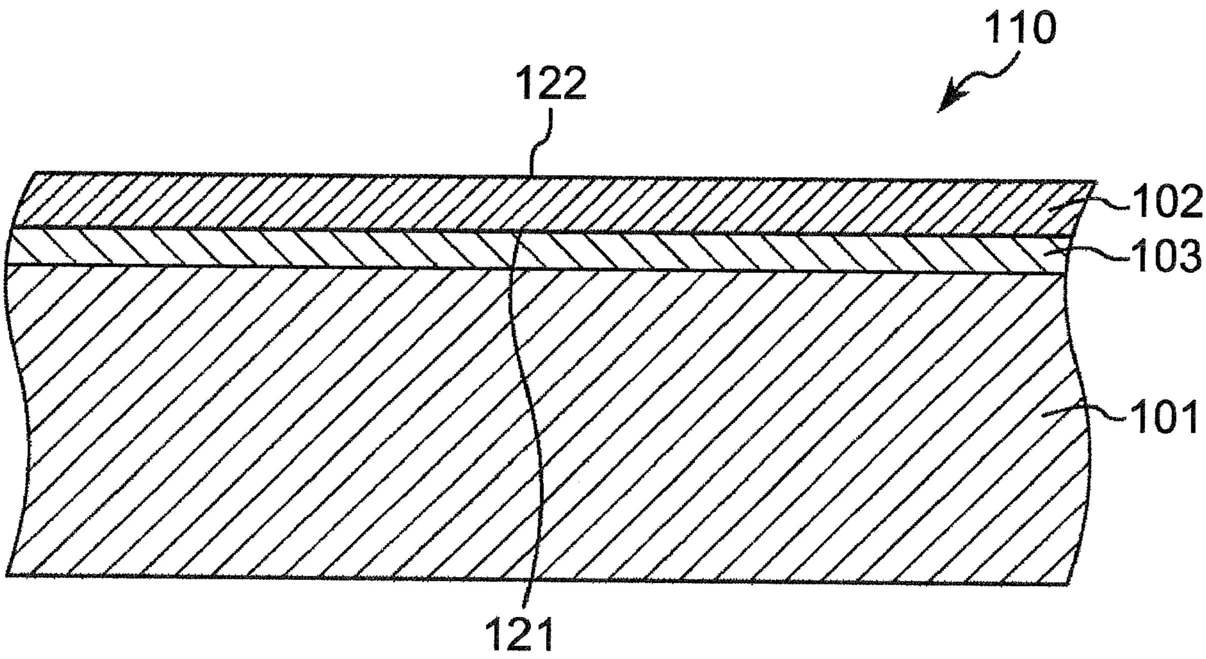


FIG. 7

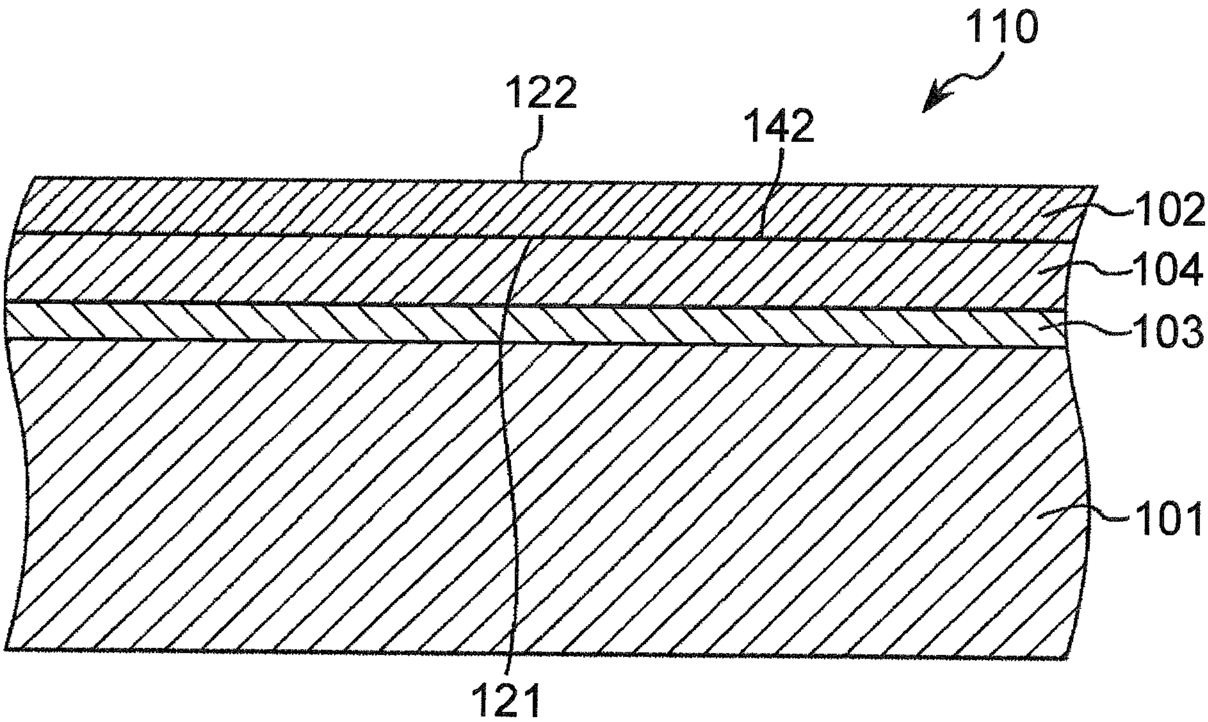


FIG. 8

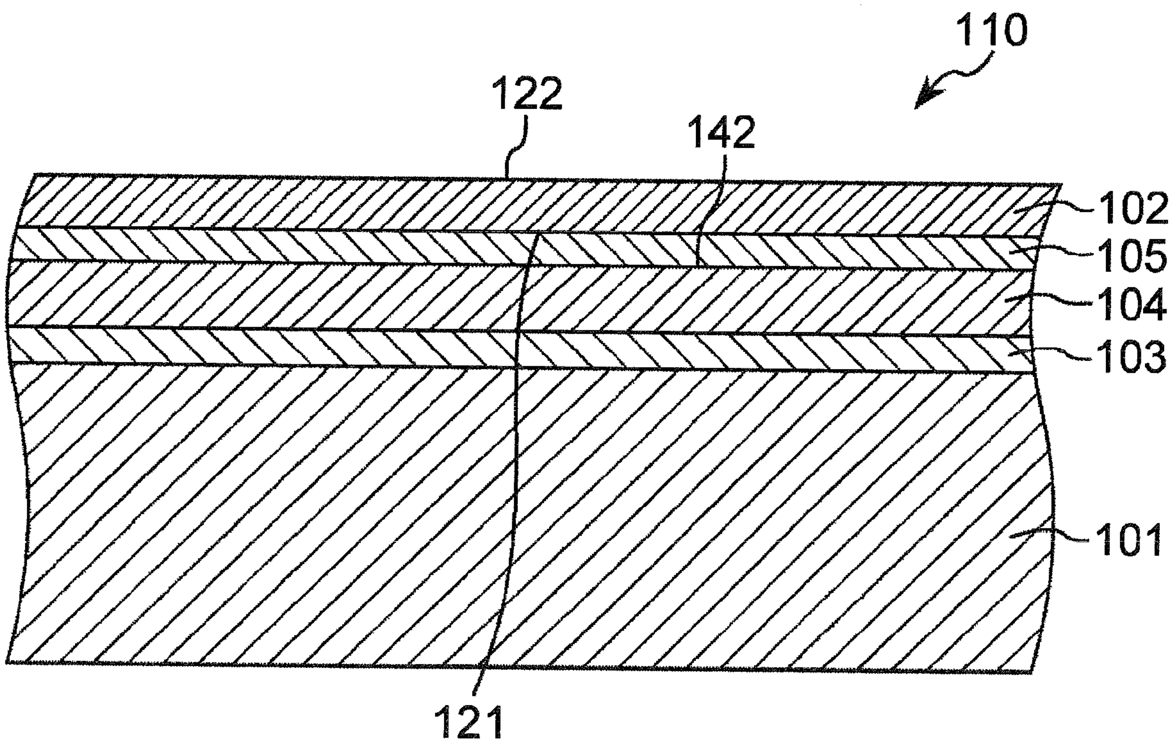
110
122
142
102
105
104
103
101
121

FIG. 9

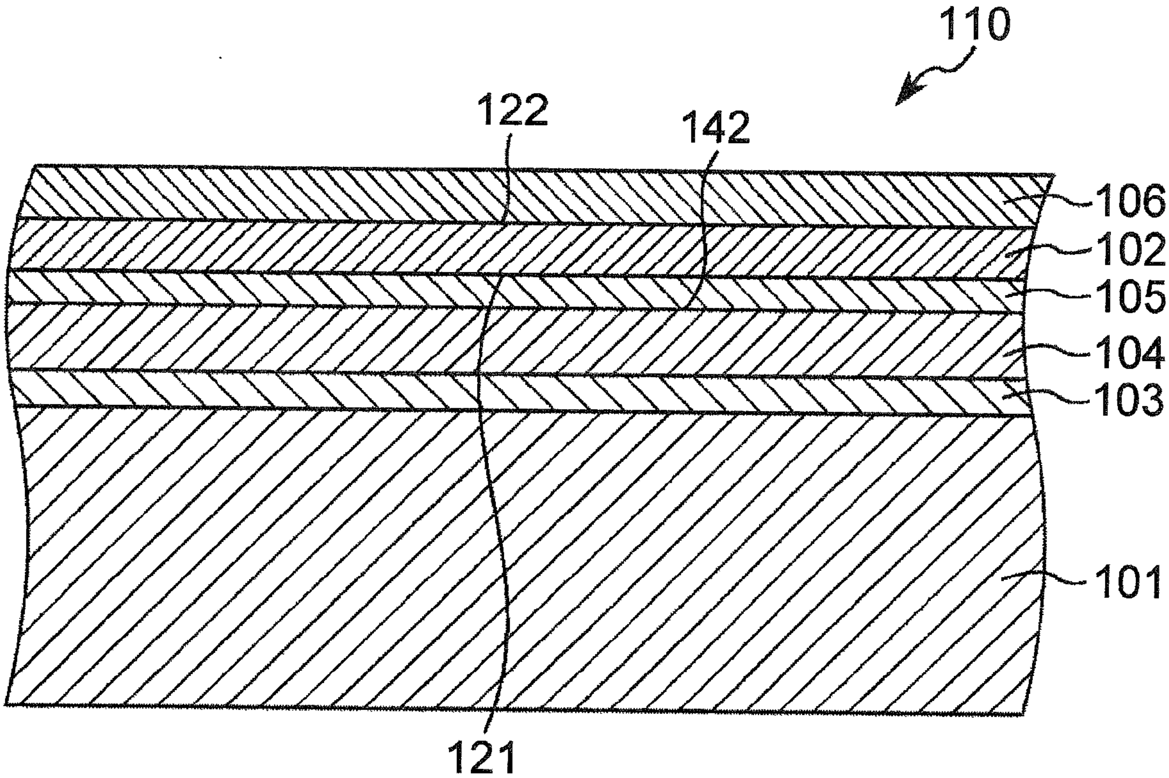
110
122
142
106
102
105
104
103
101
121

FIG. 10

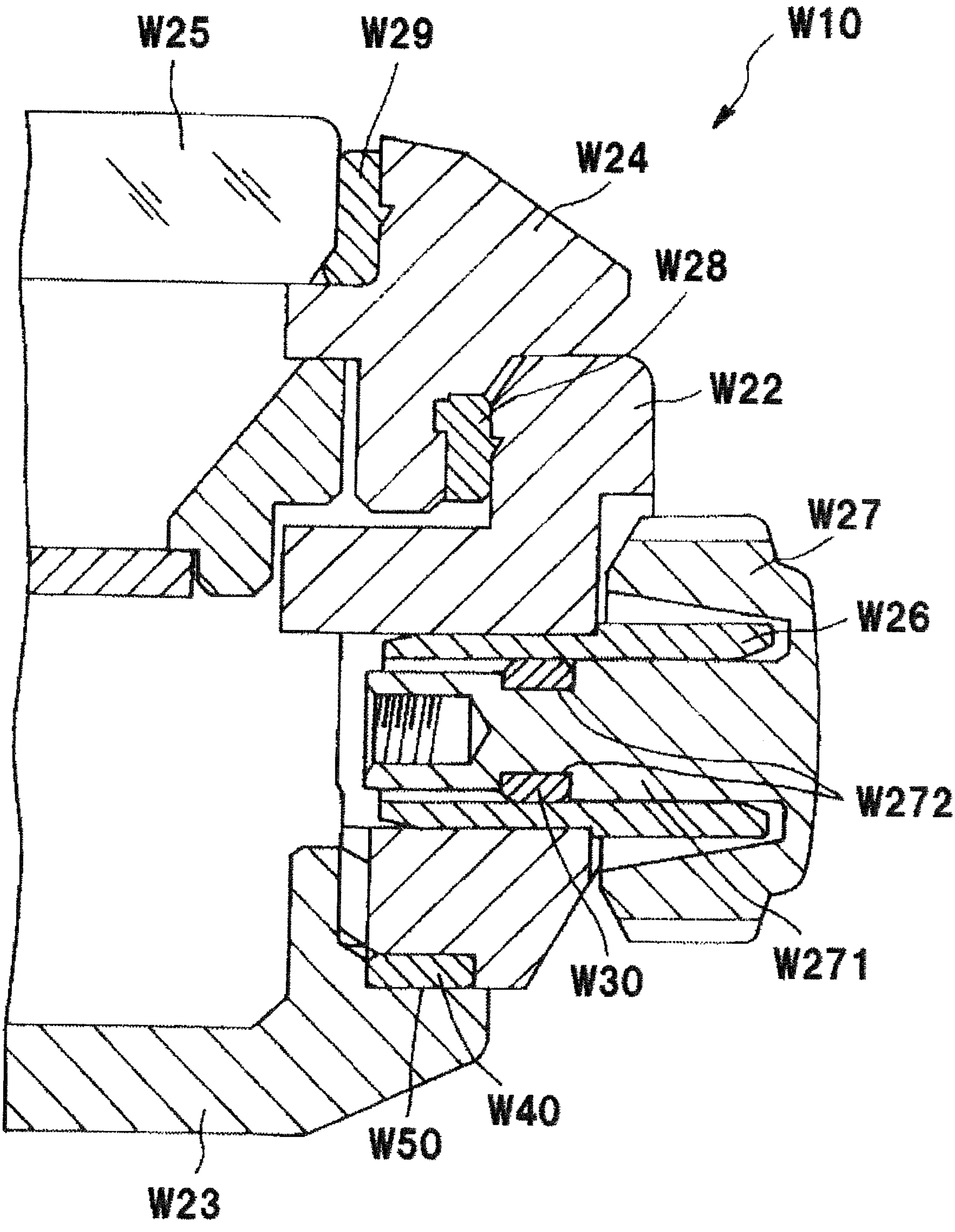


FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2990917 B